# EUROPEAN PATENT APPLICATION

(11) **EP 4 030 475 A1**
(43) Date of publication of application: **20.07.2022**
(21) Application number: 20875173.5
(22) Date of filing: 25.08.2020
(51) Int. Cl.: H01L 23/31, H01L 23/488, H01L 25/065

(54) **ENCAPSULATION STRUCTURE AND ELECTRONIC APPARATUS**

(30) Priority: 10.10.2019 CN 201910962547
(71) Applicant: Huawei Technologies Co., Ltd., Longgang District, Shenzhen, Guangdong 518129 (CN)
(72) Inventor: DOU, Zhimin, Shenzhen, Guangdong 518129 (CN); CHEN, Qiu, Shenzhen, Guangdong 518129 (CN); YE, Runqing, Shenzhen, Guangdong 518129 (CN); SHE, Yong, Shenzhen, Guangdong 518129 (CN); MA, Fuqiang, Shenzhen, Guangdong 518129 (CN)
(74) Representative: Pfenning, Meinig & Partner mbB
(86) International application number: PCT/CN2020/110960
(87) International publication number: WO 2021/068657

(57) **Abstract**

This application discloses a package structure. A second component is connected to a second substrate, so that heat of the second component can be directly transferred to the second substrate. In addition, each second heat dissipation block is connected to at least one second connecting rod, and each second heat dissipation block is connected to one second component, that is, at least a part of the second component is connected to the second connecting rod through the second heat dissipation block, so that heat of the at least a part of the second component can be further transferred to the second connecting rod through the second heat dissipation block, and then transferred, through the second connecting rod, to the second substrate or another structure connected to the second connecting rod. In this way, the heat of the second component is transferred out, and heat conduction paths of the second component are increased. In this application, there are a plurality of heat transfer paths for a component in the package structure. When the component operates and generates heat, the heat can be transferred out in time in the plurality of paths, to improve heat transfer efficiency of the package structure and enhance a heat dissipation effect of the package structure.

## Description

This application claims priority to Chinese Patent Application No. 201910962547.2, filed with the China National Intellectual Property Administration on October 10, 2019 and entitled "PACKAGE STRUCTURE AND ELECTRONIC APPARATUS", which is incorporated herein by reference in its entirety.

### TECHNICAL FIELD

This application relates to the field of packaging technologies, and in particular, to a package structure and an electronic apparatus including the package structure.

### BACKGROUND

In the trend of miniaturization and versatility of terminal products, a three-dimensional package stacking technology becomes one of the very important and effective means to increase circuit density. Based on the three-dimensional package stacking technology, more and more components such as passive components and active components are integrated together. Consequently, heat dissipation of components in a three-dimensional package stacking structure becomes an increasingly prominent and urgent problem to be resolved. Resolving the problem can avoid that heat concentration of the components in the three-dimensional package stacking structure affects proper operation of the components in the package structure or causes damage to the components in the package structure.

### SUMMARY

This application provides a package structure having a good heat dissipation effect, and an electronic apparatus including the package structure.

According to a first aspect, this application provides a package structure. The package structure includes a first package body and a second package body stacked on the first package body.

The first package body includes a first substrate and a first package layer packaged on the first substrate; a plurality of external pins are formed on a side that is of the first substrate and that is away from the first package layer, and the external pins are configured to connect to an external structure of the package structure; the first package layer includes a first package material layer and one or more first components and a plurality of first connecting rods that are embedded in the first package material layer; each first component is electrically connected to the first substrate; one end of each first connecting rod is connected to the first substrate, and the other end extends to a surface that is of the first package material layer and that is away from the first substrate; and the first connecting rod is made of a thermal conductive material.

The second package body includes a second substrate and a second package layer packaged on the second substrate; the second package layer includes a second package material layer and one or more second components, a plurality of second connecting rods, and one or more second heat dissipation blocks that are embedded in the second package material layer; each second component is connected to the second substrate; one end of each second connecting rod is connected to the second substrate, and the other end extends to a surface that is of the second package material layer and that is away from the second substrate; each second heat dissipation block is connected to at least one second connecting rod, and each second heat dissipation block is connected to one or more second components; the second connecting rod and the second heat dissipation block are made of a thermal conductive material; and the second substrate or the second connecting rod is connected to the first connecting rod.

In this application, each second component is connected to the second substrate, so that heat of the second component can be directly transferred to the second substrate. In addition, each second heat dissipation block is connected to the at least one second connecting rod, and each second heat dissipation block is connected to one second component. That is, at least a part of the second component can be connected to the second connecting rod through the second heat dissipation block. The second connecting rod is connected to the second substrate, and the second substrate or the second connecting rod is connected to the first connecting rod, so that the heat generated by the second component can be transferred to the second substrate sequentially through the second heat dissipation block and the second connecting rod, or transferred to the first substrate sequentially through the second heat dissipation block, the second connecting rod, and the first connecting rod, thereby increasing a heat transfer path of the second component and accelerating heat dissipation of the second component. In some embodiments, a plurality of external pins are formed on the first substrate, and the external pins are connected to the external structure of the package structure, so that heat transferred to the first substrate can be transferred to the external structure of the package structure through the external pins, to dissipate heat of the package structure. For this application, because the path of the second component is increased, the heat of the second component in the package structure can be quickly transferred to the first substrate, thereby improving heat dissipation efficiency of the package structure. In this application, compared with a manner in which the heat of the second component can be transferred to the first substrate only sequentially through the second substrate, the second connecting rod, and the first connecting rod, the path in which the heat of the second component is transferred to the first substrate in this application is greatly increased, so that heat dissipation in the package structure can be accelerated. In addition, because the second heat dissipation block, the first connecting rod, and the second connecting rod are disposed in the package structure, heat in the package structure can be transferred through the second heat dissipation block, the first connecting rod, and the second connecting rod, so that the heat can be quickly exchanged between the first package body and the second package body, and heat accumulation in the first package body or the second package body is avoided, thereby avoiding damage to components in the package structure caused by heat accumulation.

In some embodiments, the heat in the package structure can be further transferred out through one side of the second substrate. In this embodiment, the heat of the second component can be transferred to the second substrate in a relatively large quantity of paths, that is, can be directly transferred to the second substrate, or can be transferred to the second substrate sequentially through the second heat dissipation block and the second connecting rod, so that the heat in the package structure can be more quickly transferred to the outside of the package structure, the heat dissipation efficiency of the package structure is improved, and the package structure can have a good heat dissipation effect, so as to avoid that excessively high heat in a three-dimensional package stacking structure affects proper operation of the components in the package structure or causes damage to the components in the package structure.

In some embodiments, the first package body includes one or more first heat dissipation blocks, each first heat dissipation block is connected to at least one first connecting rod, each first heat dissipation block is connected to one or more first components, and the first heat dissipation block is made of a thermal conductive material. The first component is connected to the first substrate, so that heat of the first component can be directly transferred to the first substrate, and is transferred out through the first substrate. In addition, the first component is connected to the first connecting rod through the first heat dissipation block, and the first connecting rod is connected to the first substrate, so that the heat of the first component can be further transferred to the first connecting rod through the first heat dissipation block, then transferred to the first substrate through the first connecting rod, and transferred out through the first substrate. That is, in this embodiment, the first component at the first package layer has a relatively large quantity of heat conduction paths, so that the heat generated by the first component during operating can be quickly transferred out, and the heat dissipation efficiency of the package structure is further improved. In addition, because the heat conduction path in the package structure is increased, heat can also be quickly transferred between the first package body and the second package body, so as to avoid heat concentration at a position in the package structure, thereby avoiding damage to components caused by the heat concentration.

In some embodiments, each first heat dissipation block is located on a surface that is of the first component and that is away from the first substrate, and each first connecting rod is closer to an edge of the first package body than the first component. Alternatively, each second heat dissipation block is located on a surface that is of the second component and that is away from the second substrate, and the second connecting rod is closer to an edge of the second package body than the second component. In some embodiments, each first heat dissipation block is located on a surface that is of the first component and that is away from the first substrate, and each first connecting rod is closer to an edge of the first package body than the first component. In addition, each second heat dissipation block is located on a surface that is of the second component and that is away from the second substrate, and the second connecting rod is closer to an edge of the second package body than the second component. In this embodiment of this application, the first connecting rod is closer to the edge of the first package body than the first component, and the first heat dissipation block is connected to the first connecting rod to form a frame structure covering the surface that is of the first component and that is away from the first substrate. The frame structure can enhance internal strength of the package structure, and avoid damage to the package structure caused by an external force. When the first connecting rod or the second connecting rod is grounded, and the frame structure can form a Faraday electromagnetic shield, electromagnetic interference between the first component in the package structure and another structure in the package structure and electromagnetic interference caused by an external environment of the package structure to the first component in the package structure can be well isolated. The second connecting rod is closer to the edge of the second package body than the second component, and the second heat dissipation block is connected to the second connecting rod to form a frame structure covering the surface that is of the second component and that is away from the second substrate. The frame structure can enhance internal strength of the package structure, and avoid damage to the package structure caused by an external force. When the first connecting rod or the second connecting rod is grounded, and the frame structure forms a Faraday electromagnetic shield, electromagnetic interference between the second component in the package structure and another structure in the package structure and electromagnetic interference caused by an external environment of the package structure to the second component in the package structure can be well isolated.

In some embodiments, at least one of the first connecting rods or the second connecting rods is grounded, all the first heat dissipation blocks are integrated and electrically connected to the grounded first connecting rod or the grounded second connecting rod, and all the second heat dissipation blocks are integrated and electrically connected to the grounded first connecting rod or the grounded second connecting rod. In this embodiment of this application, because at least one of the first connecting rods or the second connecting rods is grounded, the integrated first heat dissipation blocks can be electrically connected to the grounded first connecting rod or the grounded second connecting rod, so that the integrated first heat dissipation blocks are grounded. In addition, the integrated second heat dissipation blocks can be electrically connected to the grounded first connecting rod or the grounded second connecting rod, so that the integrated second heat dissipation blocks are grounded, so that both the frame structure formed by connecting the second heat dissipation block to the second connecting rod and the frame structure formed by connecting the first heat dissipation block to the first connecting rod can form the Faraday electromagnetic shield, and electromagnetic interference between the first component and the second component in the package structure and electromagnetic interference caused by the external environment of the package structure to a component in the package structure can be well isolated.

In some embodiments, there are a plurality of first components, a plurality of first heat dissipation blocks, and a plurality of first connecting rods, the plurality of first heat dissipation blocks are disposed at intervals, the first components and the first connecting rods that are connected to different first heat dissipation blocks are different, and the different first heat dissipation blocks are configured to transmit different signals. Alternatively, there are a plurality of second components, a plurality of second heat dissipation blocks, and a plurality of second connecting rods, the plurality of second heat dissipation blocks are disposed at intervals, the second components and the second connecting rods that are connected to different second heat dissipation blocks are different, and the different second heat dissipation blocks are configured to transmit different signals. In some embodiments, there are a plurality of first components, a plurality of first heat dissipation blocks, and a plurality of first connecting rods, the plurality of first heat dissipation blocks are disposed at intervals, the first components and the first connecting rods that are connected to different first heat dissipation blocks are different, and the different first heat dissipation blocks are configured to transmit different signals. In addition, there are a plurality of second components, a plurality of second heat dissipation blocks, and a plurality of second connecting rods, the plurality of second heat dissipation blocks are disposed at intervals, the second components and the second connecting rods that are connected to different second heat dissipation blocks are different, and the different second heat dissipation blocks are configured to transmit different signals.

In this embodiment of this application, the first components and the first connecting rods that are connected to different first heat dissipation blocks are different, the different first heat dissipation blocks are configured to transmit different signals, the second components and the second connecting rods that are connected to different second heat dissipation blocks are different, and the different second heat dissipation blocks are configured to transmit different signals. That is, in some embodiments, the first heat dissipation block and the second heat dissipation block not only can perform a heat transfer function, but also can perform a signal transmission function, so that a signal transmission path in the package structure is increased.

In some embodiments, an external pin is disposed on a side that is of the second package body and that is away from the first package body, and the external pin is configured to electrically connect to the external structure of the package structure. In this embodiment of this application, the external pin is disposed on a surface that is of the first substrate and that is away from the first package layer, and the external pin is disposed on a surface that is of the second substrate and that is away from the second package layer, so that a signal can be transmitted through either the first substrate or the second substrate. Compared with a manner in which the external pin is disposed only on a single side (for example, the first substrate), a quantity of external pins increases, so that density of signals led out from the entire package structure can be increased, a quantity of components in the package structure is increased, and a quantity of integrated components in the package structure is increased, so as to facilitate miniaturization and improvement of function diversity of an electronic apparatus. In addition, compared with the manner in which the external pin is disposed only on one side, the component in the package structure not only may be connected to the external pin on the first substrate, but also may be connected to the external pin on the second substrate, so that flexibility of disposing the component and cables in the package structure can be increased, and a package structure design can be simplified.

In some embodiments, the second package layer is located on a side that is of the second substrate and that faces the first package layer, and the first connecting rod is connected to the second connecting rod. The package structure further includes a connection layer, and the connection layer is connected between the first package layer and the second package layer, and is connected to the first connecting rod and the second connecting rod.

In some embodiments, the connection layer may be solder or conductive adhesive. The first package body and the second package body are fixedly connected through the connection layer. Compared with a manner in which the first package body and the second package body are directly packaged as a whole through a package layer, it is easier to disassemble the first package body and the second package body. In some cases, when another package structure needs to be obtained, the new package structure can be obtained only by changing the second package body connected to the first package body (or changing the first package body connected to the second package body), so that the new package structure can be obtained quickly and conveniently, and the first package body or the second package body can be recycled, thereby avoiding a resource waste.

In some embodiments, the connection layer includes a plurality of connection sub-blocks disposed at intervals, there are a plurality of first connecting rods and a plurality of second connecting rods, at least a part of the first connecting rods and at least a part of the second connecting rods are disposed opposite to each other, the connection sub-blocks are connected between the first connecting rods and the second connecting rods that are opposite to each other, and the connection sub-blocks are made of a thermal and electrical conductive material.

In some embodiments, when the connection layer is the solder, the plurality of connection sub-blocks may be a plurality of solder joints disposed at intervals; or when the connection layer is the conductive adhesive, the plurality of connection sub-blocks may be a plurality of glue drops disposed at intervals.

In this embodiment, a fixed connection and an electrical connection between the first package body and the second package body are implemented by using the connection sub-blocks disposed at intervals, so that it is easier to replace the first package body or the second package body for the package structure. In addition, use of materials of the connection layer can be reduced, and production costs can be reduced. It may be understood that in some embodiments, the materials of the connection layer may alternatively be filled between the first package body and the second package body. In other words, the connection sub-blocks of the connection layer are integrated, to achieve a more stable connection effect, avoid a gap between the first package body and the second package body, and enhance strength in a thickness direction of the package structure.

In some embodiments, a surface that is of the second heat dissipation block and that is away from the second substrate exposes from the second package layer, a surface that is of the first heat dissipation block and that is away from the first substrate exposes from the first package layer, the connection layer further includes a thermal conductive block, and the thermal conductive block is connected between the surface that is of the first heat dissipation block and that exposes from the first package layer and the surface that is of the second heat dissipation block and that exposes from the second package layer.

In this embodiment of this application, the thermal conductive block is connected between the first heat dissipation block and the second heat dissipation block, to implement heat transfer between the second heat dissipation block and the second package body, improve a heat transfer speed between the first package body and the second package body, and improve soaking efficiency in the package structure. In addition, the thermal conductive block is disposed between a surface that is of the first heat dissipation block and that exposes from the first package material layer and a surface that is of the second heat dissipation block and that exposes from the second package material layer. In other words, the thermal conductive block is added between the first package body and the second package body, so that connection and fastening strength between the first package body and the second package body can be further improved.

In some embodiments, a surface that is of the second heat dissipation block and that is away from the second substrate exposes from the second package layer, a surface that is of the first heat dissipation block and that is away from the first substrate exposes from the first package layer, the surface that is of the first heat dissipation block and that exposes from the first package layer is in contact with the surface that is of the second heat dissipation block and that exposes from the second package layer, and the first heat dissipation block and the second heat dissipation block form an integrated structure.

In this embodiment of this application, a surface that is of the first connecting rod and that exposes from the first package material layer is in contact with a surface that is of the second connecting rod and that exposes from the second package material layer, and the surfaces are fastened by using an intermolecular force between the first connecting rod and the second connecting rod, so that the first heat dissipation block and the second heat dissipation block can form an integrated structure.

In some embodiments, the second package body further includes a third package layer, the third package layer is packaged on a surface that is of the second substrate and that is away from the second package layer, the third package layer includes a third package material layer and one or more third components embedded in the third package material layer, and each third component is connected to the second substrate.

In this embodiment of this application, the third package layer is packaged on the surface that is of the second substrate and that is away from the second package layer, that is, the package layer is disposed on both opposite surfaces of the second substrate. This increases a quantity of components stacked in the thickness direction of the package structure, reduces an occupied area of the package structure applied to the electronic apparatus, and increases the quantity of components in the package structure, thereby facilitating miniaturization and versatility of the electronic apparatus.

In some embodiments, the third package layer further includes a plurality of third connecting rods and one or more third heat dissipation blocks that are embedded in the third package material layer, one end of each third connecting rod is connected to the second substrate, the other end extends to a surface that is of the third package material layer and that is away from the second substrate, each third heat dissipation block is connected to at least one third connecting rod, and each third heat dissipation block is connected to the one or more third components.

In this embodiment of this application, a part of heat generated by the third component can be directly transferred to the second substrate, and a part of heat can be transferred to the second substrate sequentially through the third heat dissipation block and the third connecting rod, thereby increasing a heat transfer path of the third component, so that heat generated by the third component during operating can be relatively quickly transferred to another position in the package structure, and heat concentration is avoided. In addition, heat generated by the second substrate can be transferred to the first substrate sequentially through the second connecting rod and the first connecting rod, and transferred to the outside of the package structure through the external pin of the first substrate, to implement heat dissipation. It may be understood that heat generated by the second component at the second package layer and the first component at the first package layer can also be transferred to the third package layer, to implement soaking in the package structure, avoid heat accumulation at a position in the package structure, and avoid damage to the package structure due to heat accumulation.

In some embodiments, the second substrate includes a cable layer and an insulation layer covering a side that is of the cable layer and that is away from the second package layer, the second component is electrically connected to the cable layer, and a part of the insulation layer is hollowed out to expose a part of the cable layer. A surface that is of the second substrate and that is away from the second package layer is covered with a thermal conductive adhesive layer, the thermal conductive adhesive layer is in contact with the exposed part of the cable layer, and the thermal conductive adhesive layer is configured to transfer heat.

In this embodiment of this application, the thermal conductive adhesive layer is in contact with the cable layer of the second substrate at the hollow-out position of the insulation layer, so that heat transferred to the second substrate can be quickly dissipated through the thermal conductive adhesive layer, to improve a heat dissipation effect of the package structure. In some embodiments, a release film is disposed on a surface that is of the thermal conductive adhesive layer and that is away from the second package layer. When the package structure is fastened on another structure of an electronic device, the thermal conductive adhesive layer can be directly pasted on the another structure by removing the release film, and the operation is simple and convenient.

In some embodiments, the first component includes a formal chip, a metal sheet is stacked on a surface that is of the formal chip and that is away from the first substrate, and the first heat dissipation block is connected to the metal sheet. Alternatively, the second component includes a formal chip, a metal sheet is stacked on a surface that is of the formal chip and that is away from the second substrate, and the second heat dissipation block is connected to the metal sheet. In some embodiments, the first component includes a formal chip, a metal sheet is stacked on a surface that is of the formal chip and that is away from the first substrate, and the first heat dissipation block is connected to the metal sheet. In addition, the second component includes a formal chip, a metal sheet is stacked on a surface that is of the formal chip and that is away from the second substrate, and the second heat dissipation block is connected to the metal sheet.

A metal sheet is stacked on a surface that is of a formal chip (that is, a chip connected to a substrate in a formal manner) in the first package body and that is away from the first substrate, and the first heat dissipation block is connected to the metal sheet, so as to avoid damage to the formal chip when a laser hole is opened at the first package material layer to form the first heat dissipation block. Similarly, a metal sheet is stacked on a surface that is of a formal chip (that is, a chip connected to a substrate in a formal manner) in the second package body and that is away from the second substrate, and the second heat dissipation block is connected to the metal sheet, so as to avoid damage to the formal chip when a laser hole is opened at the second package material layer to form the second heat dissipation block.

In some embodiments, a forming material of the metal sheet may be the same as that of the first heat dissipation block and the second heat dissipation block, so that the metal sheet can form an integrated structure with the first heat dissipation block and the second heat dissipation block, to avoid increasing a contact interface, thereby enhancing a heat conduction effect.

In some embodiments, there are a plurality of first components on the first substrate, and at least two of the plurality of first components are stacked in a thickness direction of the first package body. Alternatively, there are a plurality of second components on the second substrate, and at least two of the plurality of second components are stacked in a thickness direction of the second package body. In some embodiments, there are a plurality of first components on the first substrate, and at least two of the plurality of first components are stacked in a thickness direction of the first package body. In addition, there are a plurality of second components on the second substrate, and at least two of the plurality of second components are stacked in a thickness direction of the second package body.

In this embodiment of this application, a part of first components at the first package layer are stacked in the thickness direction of the package structure, so that the components are stacked in the thickness direction of the package structure, thereby increasing density of the components in the package structure. When a same quantity of first components are packaged at the first package layer, because some first components are stacked in the thickness direction of the package structure, compared with a package structure in which all the first components are directly connected to the first substrate, in this package structure, a size of the first substrate can be reduced, and an area occupied by the package structure can be reduced.

According to a second aspect, this application further provides an electronic apparatus. The electronic apparatus includes a function module and a package structure, and the function module is electrically connected to the package structure. The package structure has a good heat dissipation effect, so that damage caused by heat concentration in the package structure is avoided, and the package structure can have a relatively long service life, thereby ensuring a service life of the electronic apparatus.

In some embodiments, the electronic apparatus includes a mainboard, the package structure and the function module are fastened on the mainboard and are electrically connected to the mainboard, and the first substrate of the package structure is closer to the mainboard than the first package layer and is electrically connected to the mainboard through the external pin.

In this embodiment of this application, the package structure is connected to each function module through a circuit of the mainboard, to implement an electrical connection between the package structure and each function module disposed on the mainboard. In addition, the package structure and a part or all of the function modules are electrically connected through the mainboard, so that at least a part of heat generated by the package structure can be transferred, through the mainboard, to a function module or another structure of the electronic device that is connected to or in contact with the mainboard, thereby avoiding damage to the package structure due to overheat caused by heat accumulation in the package structure.

In some embodiments, the electronic apparatus includes a middle frame, the middle frame is disposed opposite to the mainboard, the package structure is located between the middle frame and the mainboard and is connected to the middle frame and the mainboard, a surface that is of the second package body of the package structure and that is away from the first substrate is connected to the middle frame, and the middle frame is configured to dissipate heat.

In this embodiment of this application, the package structure is disposed between the mainboard and the middle frame and is in contact with the mainboard and the middle frame, so that a part of heat generated by the package structure is transferred to the mainboard, and a part of heat is transferred to the middle frame for dissipation. In some embodiments, the package structure is fixedly connected to both the mainboard and the middle frame, to keep the package structure stable in the electronic apparatus.

In some embodiments, the electronic device is a mobile phone, the function module includes one or more of an antenna module, a sensor module, an audio module, a camera module, a connector module, and a power module, and the package structure is electrically connected to the function modules, to use components in the package structure to control the antenna module, the audio module, the sensor module, and the camera module 500 to operate, so that the electronic apparatus implements various functions.

### BRIEF DESCRIPTION OF DRAWINGS

To describe the technical solutions in this application or in the background more clearly, the following describes the accompanying drawings for describing this application or the background.
FIG. 1 is a schematic diagram of a structure of an electronic apparatus according to an embodiment of this application;
FIG. 2 is a cross sectional schematic view of a partial structure of the electronic apparatus shown in FIG. 1;
FIG. 3 is a schematic diagram of a cross-section structure of a package structure according to an embodiment of this application;
FIG. 4 is a perspective view of a first package body of the package structure according to the embodiment shown in FIG. 3;
FIG. 5 is a perspective view of a first package body of a package structure according to some other embodiments of this application;
FIG. 6 is a schematic diagram of a cross-section structure of a package structure according to another embodiment of this application;
FIG. 7 is a schematic diagram of a cross-section structure of a package structure according to another embodiment of this application;
FIG. 8 is a schematic diagram of a cross-section structure of a package structure according to another embodiment of this application;
FIG. 9 is a schematic diagram of a cross-section structure of a package structure according to another embodiment of this application;
FIG. 10 is a schematic diagram of a cross-section structure of a package structure according to another embodiment of this application;
FIG. 11 is a schematic diagram of a cross-section structure of a package structure according to another embodiment of this application;
FIG. 12 is a schematic diagram of a cross-section structure of a package structure according to another embodiment of this application;
FIG. 13 is a schematic diagram of a partial cross section of an electronic apparatus in which the package structure according to the embodiment shown in FIG. 12 is disposed;
FIG. 14 is a schematic diagram of a cross-section structure of a package structure according to another embodiment of this application;
FIG. 15 is a schematic diagram of a cross-section structure of a package structure according to another embodiment of this application;
FIG. 16 is a schematic diagram of a cross-section structure of a package structure according to another embodiment of this application;
FIG. 17 is a schematic diagram of a cross-section structure of a package structure according to another embodiment of this application;
FIG. 18A and FIG. 18B are a flowchart of a process of preparing the package structure according to the embodiment shown in FIG. 3; and
FIG. 19a to FIG. 19k are schematic diagrams of cross-section structures of package structures in steps in FIG. 18A and FIG. 18B.

### DESCRIPTION OF EMBODIMENTS

The following describes the technical solutions in some embodiments of this application with reference to the accompanying drawings in some embodiments of this application.

It should be noted that "A and/or B" in this application includes three cases: "A", "B", or "A and B".

This application relates to a package structure, a package method, and an electronic apparatus including the package structure. The electronic apparatus may be an electronic product such as a mobile phone, a tablet computer, a wearable watch, or a router. In the package structure, components such as an active component and/or a passive component may be integrated in one package. The active component may be a component such as various chips, and the passive component may be a component such as a capacitor, an inductor, or a resistor. In embodiments of this application, the package structure is electrically connected to function modules of the electronic apparatus, so that the active component and the passive component inside the package structure cooperate to control the function modules of the electronic apparatus to operate.

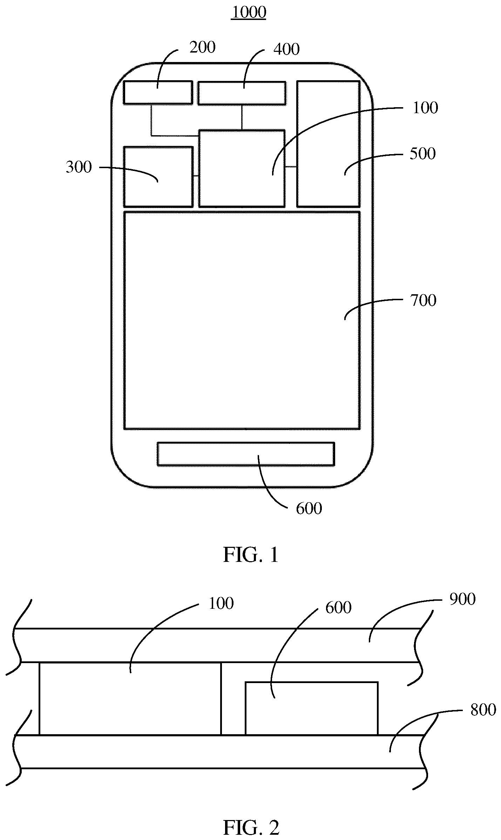

FIG. 1 is a schematic diagram of a structure of an electronic apparatus 1000 according to an embodiment of this application. The electronic apparatus includes a package structure 100 and at least one function module electrically connected to the package structure 100. A component that can control each function module to operate is packaged in the package structure 100, so that the component packaged in the package structure 100 controls each function module to operate, to implement each function of the electronic apparatus. The component in the package structure 100 includes active components such as a processor and a memory, and passive components such as a capacitor component, an inductor component, and a resistor component.

In this embodiment, the electronic apparatus 1000 is a mobile phone. Function modules of the mobile phone include an antenna module 200, an audio module 300, a sensor module 400, a camera module 500, a connector module 600, a power module 700, and the like, so that various functions of the mobile phone are implemented by using the function modules of the mobile phone. In some embodiments, an antenna module processing chip, an audio module processing chip, a sensor module processing chip, and a camera module processing chip are packaged in the package structure 100. Therefore, the package structure 100 is electrically connected to the antenna module 200, the audio module 300, the sensor module 400, and the camera module 500, so as to control, by using the components in the package structure 100, the antenna module 200, the audio module 300, the sensor module 400, and the camera module 500 to operate, so that the electronic apparatus 1000 implements various functions. It may be understood that, when the electronic apparatus 1000 is another device, the electronic apparatus 1000 may include another type of function module, and another type of component is correspondingly packaged in the package structure 100, so that each function module is electrically connected to the package structure 100, thereby implementing various functions of the electronic apparatus 1000.

In this embodiment of this application, a quantity of components packaged in the package structure 100 may be increased or decreased based on a requirement. For example, in some embodiments, a power module processing chip and a connector module processing chip may be further added to the package structure 100, and the package structure 100 is electrically connected to a connector module 600 and a power module 700, so as to extend functions of the package structure 100.

FIG. 2 is a cross sectional schematic view of a partial structure of the electronic apparatus 1000 according to some embodiments of this application. In some embodiments, the electronic apparatus 1000 may further include a mainboard 800. The package structure 100 and a part or all of the function modules are disposed on the mainboard 800. In some embodiments, the mainboard 800 is a printed circuit board (printed circuit board, PCB), and the package structure 100 is connected to each function module through a circuit of the mainboard 800, to implement an electrical connection between the package structure 100 and each function module disposed on the mainboard 800. In addition, the package structure 100 and a part or all of the function modules are electrically connected through the mainboard 800, so that at least a part of heat generated by the package structure 100 can be transferred, through the mainboard 800, to a function module or another structure of the electronic device 1000 that is connected to or in contact with the mainboard 800, thereby avoiding damage to the package structure 100 due to overheat caused by heat accumulation in the package structure 100. For example, the embodiment shown in FIG. 2 shows a case in which the package structure 100 and the connector module 600 are disposed on the mainboard 800. When heat generated by the package structure 100 is relatively high and heat generated by the connector module 600 is relatively low, the heat generated by the package structure 100 can be transferred to a position of the connector module 600 through the mainboard 800, thereby avoiding damage to the package structure 100 due to overheat caused by heat accumulation at a position of the package structure 100.

In some embodiments, the electronic apparatus 1000 further includes a middle frame 900. The middle frame 900 is disposed opposite to the mainboard 800, and the package structure 100 is connected to the middle frame 900 and the mainboard 800. The middle frame 900 can be used to dissipate heat. The package structure 100 is disposed between the mainboard 800 and the middle frame 900 and is in contact with the mainboard 800 and the middle frame 900, so that a part of heat generated by the package structure 100 is transferred to the mainboard 800, and a part of the heat is transferred to the middle frame 900 for dissipation. In some embodiments, the package structure 100 is fixedly connected to both the mainboard 800 and the middle frame 900, to keep the package structure 100 stable in the electronic apparatus 1000.

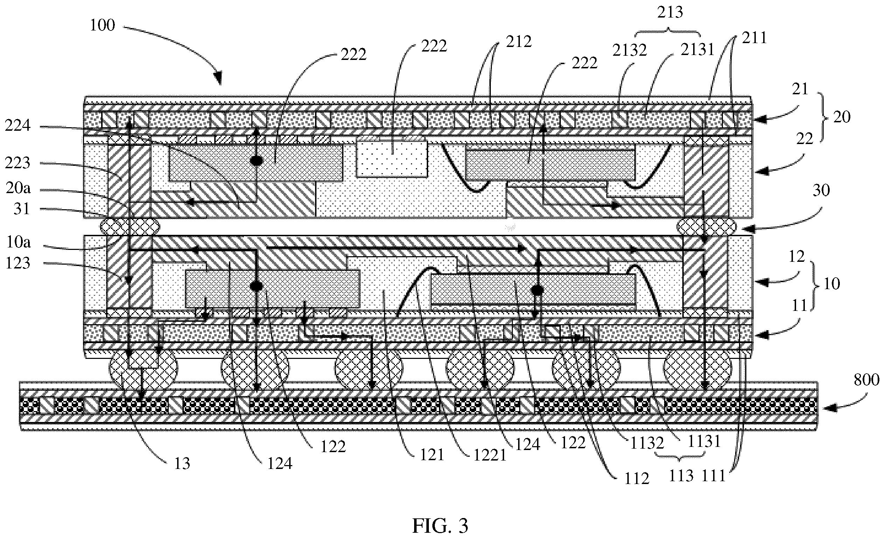

FIG. 3 is a schematic diagram of a structure of a package structure 100 according to an embodiment of this application. The package structure 100 includes a first package body 10 and a second package body 20 stacked on the first package body 10. A connection layer 30 is disposed between the first package body 10 and the second package body 20. The connection layer 30 is made of an electrical and thermal conductive material. In other words, the connection layer 30 can not only conduct electricity but also conduct heat. The first package body 10 is electrically connected to the second package body 20 through the connection layer 30, so that the first package body 10 can communicate with the second package body 20. In addition, because the connection layer 30 has a heat conduction function, heat can be transferred between the first package body 10 and the second package body 20 through the connection layer 30, thereby avoiding heat accumulation on the first package body 10 or the second package body 20.

In this embodiment, the connection layer 30 may be solder or conductive adhesive, has good thermal conductivity and electrical conductivity, and can fixedly connect the first package body 10 and the second package body 20.

In this embodiment of this application, the first package body 10 and the second package body 20 are fixedly connected through the connection layer 30. Compared with a manner in which the first package body 10 and the second package body 20 are directly packaged as a whole through a package layer, it is easier to disassemble the first package body 10 and the second package body 20. In some cases, when another package structure 100 needs to be obtained, the new package structure 100 can be obtained only by changing the second package body 20 connected to the first package body 10 (or changing the first package body 10 connected to the second package body 20), so that the new package structure 100 can be obtained quickly and conveniently, and the first package body 10 or the second package body 20 can be recycled, thereby avoiding a resource waste. For example, in some embodiments, an antenna module processing chip and an audio module processing chip are packaged in the first package body 10, and a sensor module processing chip and a camera module processing chip are packaged in the second package body 20. When a package structure 100 in which an antenna module processing chip, an audio module processing chip, a power module processing chip, and a connector module processing chip are packaged needs to be obtained, only the second package body 20 in which the sensor module processing chip and the camera module processing chip are packaged needs to be replaced with a second package body 20 in which a power module processing chip and a connector module processing chip are packaged, so as to obtain the required package structure 100.

In some embodiments of this application, a surface that is of the first package body 10 and that faces the second package body 20 is provided with a plurality of first connection terminals 10a, and a surface that is of the second package body 20 and that faces the first package body 10 is provided with a plurality of second connection terminals 20a. An electrical connection between the first package body 10 and the second package body 20 is implemented by electrically connecting at least a part of the first connection terminals 10a to at least a part of the second connection terminals 20a. In some embodiments, the at least a part of the first connection terminals 10a and the at least a part of the second connection terminals 20a are disposed opposite to each other. In this embodiment, the connection layer 30 includes a plurality of connection sub-blocks 31 disposed at intervals, and each connection sub-block 31 is connected between the first connection terminal 10a and the second connection terminal 20a that are disposed opposite to each other, so as to implement the electrical connection between the first package body 10 and the second package body 20. An orthographic projection of the second connection terminal 20a on the surface that is of the first package body 10 and that faces the second package body 20 at least partially overlaps the first connection terminal 10a disposed opposite to the second connection terminal 20a.

In this embodiment of this application, when the connection layer 30 is the solder, the plurality of connection sub-blocks 31 may be a plurality of solder joints disposed at intervals; or when the connection layer 30 is the conductive adhesive, the plurality of connection sub-blocks 31 may be a plurality of glue drops disposed at intervals.

In this embodiment, a fixed connection and an electrical connection between the first package body 10 and the second package body 20 are implemented by using the connection sub-blocks 31 disposed at intervals, so that it is easier to replace the first package body 10 or the second package body 20 for the package structure 100. In addition, use of materials of the connection layer 30 can be reduced, and production costs can be reduced. It may be understood that in some embodiments, materials of the connection layer 30 may alternatively be filled between the first package body 10 and the second package body 20. In other words, the connection sub-blocks of the connection layer 30 are integrated, to achieve a more stable connection effect, avoid a gap between the first package body 10 and the second package body 20, and enhance strength in a thickness direction of the package structure 100.

The first package body 10 includes a first substrate 11 and a first package layer 12 packaged on the first substrate 11. The first substrate 11 is a circuit board, and includes two opposite insulation layers 111 and at least one cable layer 112 disposed between the two insulation layers 111. When there are a plurality of cable layers 112, the first substrate 11 further includes a signal interconnection layer 113 disposed between two adjacent cable layers 112. The signal interconnection layer 113 includes an insulation material layer 1131 and a connection line 1132 that penetrates the insulation material layer 1131. The insulation material layer 1131 separates and insulates two adjacent cable layers 112, and the connection line 1132 embedded in the insulation material layer 1131 is connected to the adjacent cable layers 112, so that the plurality of cable layers 112 can communicate with each other. In this embodiment, there are two cable layers 112. It may be understood that there may be more cable layers 112.

In some embodiments, there is only one insulation layer 111. Specifically, there may be no insulation layer 111 close to a side of the first package layer 12, and the first package layer 12 is directly packaged on the cable layer 112 of the first substrate 11.

In this embodiment, a solder pad connected to the cable layer 112 is further disposed on a surface that is of the insulation layer 111 and that is away from the cable layer 112, and the solder pad is configured to implement a connection between a structure such as a component and the cable layer 112 of the first substrate 11.

An external pin 13 is disposed on a surface that is of the first substrate 11 and that is away from the first package layer 12, and the external pin 13 is configured to electrically connect to an external structure of the package structure 100. The external structure of the package structure 100 is another structure, module, or component that is outside the package structure and that is electrically connected to the package structure. The external pin 13 is connected to the cable layer 112, so that the first substrate 11 is electrically connected to the external structure (for example, each function module of the electronic apparatus 1000) of the package structure 100, so that a structure that is in the package structure 100 and that is electrically connected to the first substrate 11 is electrically connected to the external structure of the package structure 100.

When the package structure 100 is disposed on the mainboard 800, the first substrate 11 is connected to the mainboard 800 through the external pin 13. A signal generated by an operating module that is electrically connected to the mainboard 800 is transmitted to the package structure 100 sequentially through the mainboard 800 and the external pin 13; or a signal generated through processing in the package structure 100 is transmitted to the operating module sequentially through the first substrate 11, the external pin 12, and the mainboard 800, so as to implement communication between the package structure 100 and the operating module. In addition, a part of heat generated during operating of a component in the package structure 100 may be transferred to the mainboard 800 through the first substrate 11, and the mainboard 800 dissipates or transfers, to another structure or operating module in the electronic device 1000, the heat generated during operating of the component in the package structure 100, so as to avoid heat accumulation at a position of the package structure 100, and avoid damage caused by excessively high heat of the package structure 100.

The first package layer 12 includes a first package material layer 121, and one or more first components 122, a plurality of first connecting rods 123, and one or more first heat dissipation blocks 124 that are embedded in the first package material layer 121. The first component 122 is a component in the package structure 100, and may be an active component such as a chip, or may be a passive component such as a capacitor, an inductor, or a resistor. Each first component 122 is electrically connected to the first substrate 11. The first component 122 may be directly connected to the first substrate 11, or may be indirectly connected to the first substrate 11 through another structure.

In this embodiment, the first component 122 is disposed on the first substrate 11, and a pin 1211 of the first component 122 is connected to the solder pad on the first substrate 11, so that the first component 122 is directly connected to the first substrate 11. There may be one or more first components 122. When there are a plurality of first components 122, because the plurality of first components 122 are all disposed on the first substrate 11 and are electrically connected to the first substrate 11, the first components 122 can communicate with each other through the cable layer 112 of the first substrate 11. Cabling of the cable layer 112 of the first substrate 11 is designed, to connect the first component 122 electrically connected to the first substrate 11.

In this embodiment of this application, the first component 122 may be electrically connected to the first substrate 11 through surface mounting, bonding, or the like.

In some embodiments of this application, when the first component 122 is a chip, the chip may be connected to the first substrate 11 in a formal mounting manner or a flip mounting manner. For example, in the embodiment shown in FIG. 3, the first package layer 12 includes two first components 122, and both the two first components 122 are chips. One of the first components 122 is connected to the first substrate 11 in the flip mounting manner. To be specific, a pin of the first component 122 is located on a side that is of the first component 121 and that faces the first substrate 11, and the pin of the first component 122 is directly connected to the solder pad on the first substrate 11, so as to implement an electrical connection between the first component 122 and the first substrate 11. The other first component 122 is connected to the first substrate 11 in the formal mounting manner. To be specific, a pin of the first component 122 is located on a side that is of the first component 122 and that is away from the first substrate 11, and the pin is bonded to the solder pad on the first substrate 11 through a bonding wire 1221, so as to implement an electrical connection between the first component 122 and the first substrate 11.

In some embodiments, a metal sheet is stacked on a surface that is of a formal chip (that is, a chip connected to a substrate in a formal manner) and that is away from the first substrate 11, and the first heat dissipation block 124 is connected to the metal sheet, so as to avoid damage to the formal chip when a laser hole is opened at the first package material layer 121 to form the first heat dissipation block 124. A forming material of the metal sheet may be the same as or different from that of the first heat dissipation block 124. In this embodiment, the forming material of the metal sheet is the same as that of the first heat dissipation block 124, and the metal sheet forms an integrated structure with the first heat dissipation block 124, to avoid increasing a contact interface, thereby enhancing a heat conduction effect.

One end of each first connecting rod 123 is connected to the first substrate 11, and the other end extends to a surface that is of the first package material layer 121 and that is away from the first substrate 11, and is connected to the second package body 20. In this embodiment, an end surface that is of the first connecting rod 123 and that extends to the surface that is of the first package material layer 121 and that is away from the first substrate 11 is the first connection terminal 10a of the first package body 10. Specifically, the first connecting rod 123 is fastened on the first substrate 11 through conductive adhesive or solder, and is electrically connected to the first substrate 11 through the conductive adhesive or a solder pad. In this embodiment of this application, both the first connecting rod 123 and the first heat dissipation block 124 are made of an electrical and thermal conductive material. In other words, both the first connecting rod 123 and the first heat dissipation block 124 have a relatively high thermal conductivity (the thermal conductivity is greater than 10 W/m·K) and can conduct heat, and the first connecting rod 123 and the first heat dissipation block 124 can also conduct electricity. In some embodiments of this application, the first connecting rod 123 and the first heat dissipation block 124 are made of metal materials such as gold, silver, copper, and aluminum. Materials of the first connecting rod 123 and a second heat dissipation block may be the same or may be different. In this embodiment, both the first connecting rod 123 and the first heat dissipation block 124 are made of metal copper, and the first connecting rod 123 and the first heat dissipation block 124 are formed into an integrated structure. It may be understood that in some embodiments, the first connecting rod 123 and/or the first heat dissipation block 124 may alternatively be made of another nonmetallic conductive material. Alternatively, in the following embodiments, the first connecting rod 123 and/or the first heat dissipation block 124 may be a heat pipe, to achieve a better heat conduction effect.

Each first heat dissipation block 124 is connected to at least one first connecting rod 123, and each first heat dissipation block 124 is connected to one or more first components 122, so that at least a part of heat generated by the first components 122 during operating can be transferred to the first connecting rod 123 through the first heat dissipation block 124. In this embodiment, quantities of first components 122 and first heat dissipation blocks 124 are the same, and both are two. Each first heat dissipation block 124 corresponds to one first component 122 and is connected to the corresponding first component 122. It may be understood that in some embodiments, the quantity of first components 122 may be greater than the quantity of first heat dissipation blocks 124, and only some of the first components 122 are connected to the first heat dissipation blocks 124. For example, in some embodiments, there are some active components and some passive components in the plurality of first components 122. Because the active components usually emit more heat during operating than the passive components, only the active components may be connected to the first heat dissipation block 124, to enhance a heat dissipation effect of the active components. An arrow in FIG. 3 shows a heat transfer path in the package structure 100. In this embodiment, because the first component 122 is disposed on the first substrate 11 and is directly connected to the first substrate 11, a part of heat of the first component 122 is directly transferred to the first substrate 11, and is transferred to the outside of the package structure 100 through the first substrate 11. In addition, the first substrate 11 is further connected to the first heat dissipation block 124. A part of heat of the first component 122 may be further transferred to the first substrate 11 through the first heat dissipation block 124 and the first connecting rod 123, and is transferred to the outside of the package structure 100 through the first substrate 11. In this embodiment, because the first substrate 11 is connected to the mainboard 800 through the external pin 13, all heat transferred to the first substrate 11 can be transferred to the mainboard 800. In this embodiment, each first component 122 is connected to a corresponding first heat dissipation block 124, so that each first component 122 can dissipate heat through the first heat dissipation block 124. It may be understood that in some embodiments, only some of the first components 122 may be connected to the first heat dissipation block 124, so that only some of the first components 122 can dissipate heat through the first heat dissipation block 124. For example, when one first component 122 emits a relatively large amount of heat, and the other first component 122 emits a relatively small amount of heat, only one first heat dissipation block 124 may be disposed to connect to the first component 122 that emits the relatively large amount of heat. This ensures a heat dissipation effect, reduces a quantity of first heat dissipation blocks 124, and reduces costs.

In this embodiment of this application, the first connecting rod 123 is connected to the first substrate 11, and the first heat dissipation block 124 is connected to the first component 122 and the first connecting rod 123. Therefore, a part of the heat generated by the first component 122 can be transferred to the first substrate 11 through the first heat dissipation block 124 and the first connecting rod 123. Compared with a package structure without the first connecting rod 123 and the first heat dissipation block 124, in the package structure 100 according to this embodiment of this application, the first heat dissipation block 124 and the first connecting rod 123 are added, so that a transmission path of heat generated by the first component 122 can be increased, and a heat dissipation capability of the package structure 100 can be improved.

It may be understood that in some embodiments, because heat generated by the first component 122 during operating is not high, or because the first component 122 is directly connected to the first substrate 10, most of the heat can be directly transferred to the first substrate 10, and heat dissipation efficiency is relatively high. Therefore, the first package layer 12 may alternatively not have the first heat dissipation block 124.

In this embodiment, both the first connecting rod 123 and the first heat dissipation block 124 are made of a metal material, so that the first connecting rod 123 and the first heat dissipation block 124 have relatively high strength relative to the first package material layer 121. In addition, to achieve a better heat conduction effect, the first connecting rod 123 and the first heat dissipation block 124 occupy a relatively large volume in the first package body 10. For example, in some embodiments of this application, a diameter of the first connecting rod 123 is greater than 200 µm, to achieve a better heat conduction effect. Therefore, in this embodiment, a frame architecture formed by connecting the first heat dissipation block 124 and the first connecting rod 123 is embedded into the first package material layer 121, so that strength of the first package body 10 can be further enhanced.

Both the first heat dissipation block 124 and the first connecting rod 123 can conduct electricity, and the first connecting rod 123 is connected to the first substrate 11. Therefore, in some embodiments, a signal may be input into the first connecting rod 123 through the first substrate 11, and the signal can be transferred to the first component 122 through the first connecting rod 123 and the first heat dissipation block 124. Alternatively, a signal generated by the first component 122 can be transferred to the first substrate 11 through the first connecting rod 123 and the first heat dissipation block 124, so as to communicate with the outside through the first substrate 11. In other words, the first connecting rod 123 and the first heat dissipation block 124 can further perform a signal transmission function, increase signal transmission paths in the package structure 100, and implement signal redistribution. In this embodiment, the first substrate 11 is electrically connected to the external structure of the package structure 100 through the external pin 13, to implement signal communication inside and outside the package structure 100.

It may be understood that, based on different signals input into the first connecting rod 123 and the first heat dissipation block 124, a structure formed by connecting the first connecting rod 123 and the first heat dissipation block 124 has different functions. For example, in some embodiments, the external pin 13 is electrically connected to a power module, that is, the first connecting rod 123 inputs a power signal, so that a structure formed by connecting the first connecting rod 123 and the first heat dissipation block 124 can be used as a power network of the package structure 100, and can supply, by using the power network, power to each component that is at the first package layer 12 and that is connected to each heat dissipation block. Alternatively, in some embodiments, the external pin 13 connected to the first connecting rod 123 may be grounded, and a ground return current in the package structure 100 can pass from the first component 122 to the ground sequentially through the first heat dissipation block 124, the first connecting rod 123, a connection line of the first substrate 11, and the external pin 13, thereby forming a low-impedance ground network path. This path can form a good Faraday electromagnetic shield.

When structures formed by connecting the first connecting rod 123 and the first heat dissipation block 124 have different functions, the structures formed by connecting the first connecting rod 123 and the first heat dissipation block 124 and positions of the structures in the package structure 100 may be different. In this embodiment, the first heat dissipation block 124 is located on a surface that is of the first component 122 and that is away from the first substrate 11, the first connecting rod 123 is closer to an edge of the first package body 10 than the first component 122, and the first heat dissipation block 124 is connected to the first connecting rod 123 to form a frame structure covering the surface that is of the first component 122 and that is away from the first substrate 11. The frame structure can enhance internal strength of the package structure 100, and avoid damage to the package structure 100 caused by an external force. When the first connecting rod 123 is grounded through the external pin 13 and the frame structure forms the Faraday electromagnetic shield, electromagnetic interference between the first component 122 in the package structure 100 and another structure in the package structure 100 and electromagnetic interference caused by an external environment of the package structure 100 to the first component 122 in the package structure 100 can be well isolated.

It may be understood that in some other embodiments of this application, the first connecting rod 123 may be partially closer to an edge of the first package body 10 than the first component 122, or may be partially disposed at any other position on the first substrate 11. For example, the first connecting rod 123 may be disposed between adjacent first components 122 located on the first substrate 11. A quantity of first connecting rods 123 connected to the first substrate 11 in the package structure 100 is increased, so that a channel through which heat of the first component 122 is transferred to the first substrate 11 can be increased, thereby improving heat dissipation efficiency of the first component 122. In addition, a volume occupied by the first connecting rod 123 in the first package layer 12 can be increased, and strength of the package structure 100 can be enhanced.

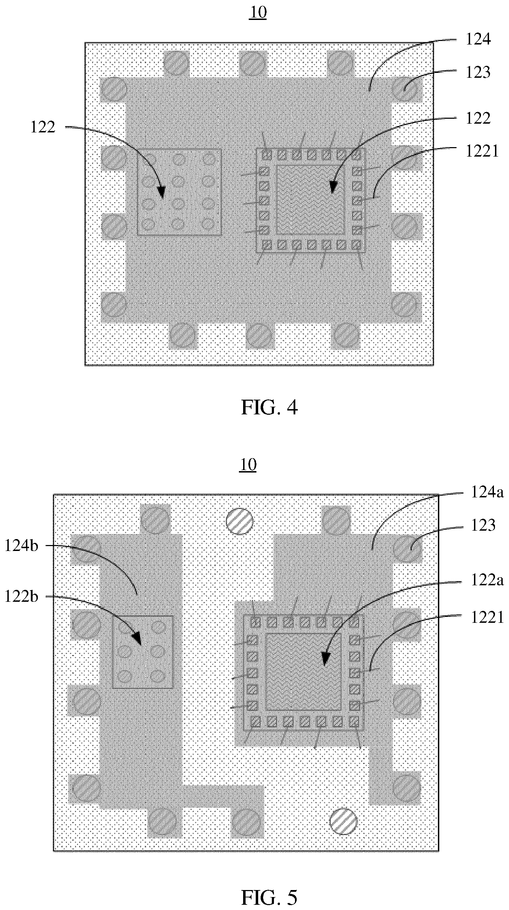

FIG. 4 is a perspective view of the first package body 10 of the package structure 100 according to the embodiment shown in FIG. 3. In this embodiment, the first heat dissipation blocks 124 connected to the first components 122 are integrated, and the first connecting rods 123 are all connected to the first heat dissipation blocks 124. In some cases, it may also be considered that there is only one first heat dissipation block 124 in the embodiment shown in FIG. 4, and all the first components 122 are connected to the same first heat dissipation block 124. In other words, in this embodiment, the first heat dissipation block 124 and the first connecting rod 123 of the first package body 10 are connected to an integrated frame. In this embodiment, the first heat dissipation block 124 and the first connecting rod 123 are connected as an integrated frame. When at least one first connecting rod 123 is grounded, the integrated frame formed by the first heat dissipation block 124 and the first connecting rod 123 forms a Faraday electromagnetic shield, electromagnetic interference between the first component 122 in the package structure 100 and another structure in the package structure 100 and electromagnetic interference caused by an external environment of the package structure 100 to the first component 122 in the package structure 100 can be well isolated. In addition, no gap needs to be reserved between the first heat dissipation blocks 124, so that the first heat dissipation block 124 and the first connecting rod 123 can occupy a relatively large volume in the first package body 10, thereby achieving a better heat conduction effect and a better strength enhancement effect.

FIG. 5 is a perspective view of the first package body 10 of the package structure 100 according to some other embodiments of this application. In this embodiment, the first connecting rod 123 and the first heat dissipation block 124 can provide a signal for the first component, to ensure directivity of signal transmission. First heat dissipation blocks 124 connected to different first components 122 are disposed at intervals, and first connecting rods 123 connected to different first heat dissipation blocks 124 are also disposed at intervals. In this embodiment, there are two first components 122: a first component 122a and a first component 122b. There are also two first heat dissipation blocks 124: a first heat dissipation block 124a and a first heat dissipation block 124b. The first heat dissipation block 124a is connected to the first component 122a, and the first heat dissipation block 124b is connected to the first component 122b. The first heat dissipation block 124a and the first heat dissipation block 124b are disposed at intervals. In some embodiments, the first connecting rod 123 connected to the first heat dissipation block 124a and the first connecting rod 123 connected to the first heat dissipation block 124a are connected to different external pins 13 through the cable layer 112 on the first substrate 11, and different external pins 13 input different signals, the first connecting rod 123 connected to the first heat dissipation block 124a and the first connecting rod 123 connected to the first heat dissipation block 124a separately input different signals, so as to separately input different signals into the first component 122a and the first component 122b.

Refer to FIG. 3 again. In this embodiment, a structure of the second package body 20 is similar to a structure of the first package body 10, and includes a second substrate 21 and a second package layer 22 packaged on the second substrate 21. The second package layer 22 is located on a side that is of the second substrate 21 and that faces the first package layer 12.

The second substrate 21 is a circuit board, and includes two opposite insulation layers 211 and at least one cable layer 212 disposed between the two insulation layers 211. When there are a plurality of cable layers 212, the second substrate 21 further includes a signal interconnection layer 213 disposed between two adjacent cable layers 212. The signal interconnection layer 213 includes an insulation material layer 2131 and a connection line 2132 that penetrates the insulation material layer 2131. The insulation material layer 2131 separates and insulates two adjacent cable layers 212, and the connection line 2132 embedded in the insulation material layer 2131 is connected to the adjacent cable layers 212, so that the plurality of cable layers 212 can communicate with each other. In this embodiment, there are two cable layers 212. It may be understood that there may be more cable layers 212.

In some embodiments, the second substrate 21 may alternatively include only one insulation layer. Specifically, there is no insulation layer on a side that is of the second substrate 21 and that faces the second package layer 22, so that the second package layer 22 is directly packaged on the cable layer 212 of the second substrate 21.

In this embodiment, a solder pad connected to the cable layer 212 is further disposed on a surface that is of the insulation layer 211 and that is away from the cable layer 212, and the solder pad is configured to implement a connection between a structure such as a component and the cable layer 212 of the second substrate 21.

The second package layer 22 includes a second package material layer 221, and one or more second components 222, a plurality of second connecting rods 223, and one or more second heat dissipation blocks 224 that are embedded in the second package material layer 221. The second component 222 may be an active component such as a chip, or may be a passive component such as a capacitor, an inductor, or a resistor. Each second component 222 is connected to the second substrate 21. The second component 222 may be directly connected to the second substrate, or may be indirectly connected to the second substrate 21 through another structure.

In some embodiments, the second component 222 may be a chip, and the chip may be connected to the second substrate 21 in a formal mounting manner or a flip mounting manner. A metal sheet is stacked on a surface that is of a formal chip (that is, a chip connected to a substrate in a formal manner) and that is away from the second substrate 12, and the second heat dissipation block 224 is connected to the metal sheet, so as to avoid damage to the formal chip when a laser hole is opened at the second package material layer 221 to form the second heat dissipation block 224. A forming material of the metal sheet may be the same as or different from that of the second heat dissipation block 224. In this embodiment, the forming material of the metal sheet is the same as that of the second heat dissipation block 224, and the metal sheet forms an integrated structure with the second heat dissipation block 224, to avoid increasing a contact interface, thereby enhancing a heat conduction effect.

In this embodiment, the second component 222 is disposed on the second substrate 21, and a pin of the second component 222 is connected to a solder pad on the second substrate 21, so that the second component 222 is directly connected to the second substrate 21. There may be one or more second components 222. When there are a plurality of second components 222, the plurality of second components 222 are all disposed on the second substrate 21 and connected to the solder pad on the second substrate 21, and the solder pad is connected to the cable layer 212 of the second substrate 21, so that the plurality of second components 222 may be electrically connected to each other through the cable layer 212 of the second substrate 21, and the second components 222 can communicate with each other through the cable layer 212 of the second substrate 21. In this embodiment of this application, the second component 222 may be electrically connected to the second substrate 21 through surface mounting, bonding, or the like. In this embodiment of this application, when the second component 222 is a chip, the chip may also be connected to the first substrate 11 in a formal mounting manner or a flip mounting manner.

One end of each second connecting rod 223 is connected to the second substrate 21, and the other end extends to a surface that is of the second package material layer 221 and that is away from the second substrate 21, and is connected to the second package body 20. In this embodiment, an end surface that is of the second connecting rod 223 and that extends to the surface that is of the second package material layer 221 and that is away from the second substrate 21 is the second connection terminal 20a of the second package body 20.

Both the second connecting rod 223 and the second heat dissipation block 224 are made of an electrical and thermal conductive material. In other words, both the second connecting rod 223 and the second heat dissipation block 224 have a relatively high thermal conductivity (the thermal conductivity is greater than 10 W/m·K) and can conduct heat, and the second connecting rod 223 and the second heat dissipation block 224 can also conduct electricity. In some embodiments, the second connecting rod 223 and the second heat dissipation block 224 may be made of a metal material such as gold, silver, copper, or aluminum. Materials of the second connecting rod 223 and the second heat dissipation block 224 may be the same or may be different. In this embodiment, both the second connecting rod 223 and the second heat dissipation block 224 are made of metal copper, and the second connecting rod 223 and the second heat dissipation block 224 form an integrated structure. In some embodiments, the second connecting rod 223 and/or the second heat dissipation block 224 may alternatively be made of another nonmetallic conductive material. Alternatively, in the following embodiments, the second connecting rod 223 and/or the second heat dissipation block 224 may be a heat pipe, to achieve a better heat conduction effect.

In this embodiment, at least a part of the first connection terminals 10a and at least a part of the second connection terminals 20a are disposed opposite to each other. In other words, at least a part of the first connecting rod 123 and at least a part of the second connecting rod 223 are disposed opposite to each other. The connection sub-block 31 is connected between the first connection terminal 10a and the second connection terminal 20a that are disposed opposite to each other. In other words, the connection sub-block 31 is connected between the first connecting rod 123 and the second connecting rod 223 that are disposed opposite to each other. That at least a part of the first connecting rod 123 and at least a part of the second connecting rod 223 are disposed opposite to each other means that an orthographic projection of the at least a part of the first connecting rod 123 and an orthographic projection of the at least a part of the second connecting rod 223 that are on a surface that is of the first substrate 11 and that faces the first package layer 12 partially overlap or completely overlap. In this embodiment, orthographic projections that are of the first connecting rod 123 and the second connecting rod 223 disposed opposite to each other and that are on the surface that is of the first substrate 11 and that faces the first package layer 12 completely overlap, so that when the package structure 100 is under pressure in a thickness direction, because both height directions of the first connecting rod 123 and the second connecting rod 223 are the same as the thickness direction of the package structure 100, and the first connecting rod 123 and the second connecting rod 223 are corresponding to a same position on the first substrate 11, a better support effect can be implemented, and damage to the package structure 100 caused by pressure in the thickness direction is avoided. In addition, a heat transfer path for transferring heat from the first connecting rod 123 to the second connecting rod 223 is the shortest, so that efficient heat transfer is implemented.

Each second heat dissipation block 224 is connected to at least one second connecting rod 223, and each second heat dissipation block 224 is connected to one or more second components 222, so that at least a part of heat of the second components 222 can be transferred to the second connecting rod 223 through the second heat dissipation block 224. In this embodiment, a quantity of second components 222 is greater than a quantity of second heat dissipation blocks 224, and only a part of the second components 222 are connected to the second heat dissipation blocks 224. In this embodiment, the plurality of second components 222 include two active components and one passive component. Because the active component usually emits more heat during operating than the passive component, only the active component is connected to the second heat dissipation block 224, to enhance a heat dissipation effect of the active component. It may be understood that in some embodiments, the quantity of second heat dissipation blocks 224 may be the same as the quantity of second components 222, and each second component 222 is connected to a corresponding second heat dissipation block 224, to dissipate at least a part of heat of the second component 222 through the second heat dissipation block 224.

In this embodiment, because the second components 222 are all disposed on the second substrate 21 and are directly connected to the second substrate 21, a part of heat of the second components 222 can be directly transferred to the second substrate 21, and is transferred to the outside of the package structure 100 through the second substrate 21. In addition, the second substrate 21 is further connected to the second heat dissipation block 224. Apart of heat of the second component 222 may be further transferred to the second substrate 21 through the second heat dissipation block 224 and the second connecting rod 223, and is transferred to the outside of the package structure 100 through the second substrate 21. In addition, a part of heat of the second component 222 may be further transferred to the first connecting rod 123 through the second connecting rod 223 and the connection layer 30, and then transferred to the first substrate 11. It may be understood that in some embodiments, a part of heat generated by the first component 122 may also be transferred to the second substrate 21 sequentially through the first heat dissipation block 124, the first connecting rod 123, the connection layer 30, and the second connecting rod 223. In this embodiment, the second package layer 22 includes three second components 222, and two of the second components 222 are connected to corresponding second heat dissipation blocks 224. In this embodiment, only a part of the second components 222 are connected to the second heat dissipation block 224, so that only a part of heat of the second components 222 can be dissipated through the second heat dissipation block 224. For example, when one second component 222 emits a relatively large amount of heat, and the other second component 222 emits a relatively small amount of heat, only one second heat dissipation block 224 may be disposed to connect to the second component 222 that emits the relatively large amount of heat. This ensures a heat dissipation effect, reduces a quantity of second heat dissipation blocks 224, and reduces costs. It may be understood that in some embodiments, each second component 222 is connected to one second heat dissipation block 224, so that heat of each second component 222 can be partially dissipated through the second heat dissipation block 224, thereby improving heat dissipation efficiency of the package structure 100.

In this embodiment, the first heat dissipation block 124 is connected to the first connecting rod 123, the first connecting rod 123 is connected to the first substrate 11, the second heat dissipation block 224 is connected to the second connecting rod 223, the second connecting rod 223 is connected to the second substrate 21, and the first connecting rod 123 is connected to the second connecting rod 223. Therefore, the first heat dissipation block 124, the first connecting rod 123, the second heat dissipation block 224, the second connecting rod 223, the first substrate 11, and the second substrate 21 are connected to form a heat dissipation frame, so that heat conduction paths of the first component 122 and the second component 222 can be increased. Compared with a package structure without the first heat dissipation block 124 and the second heat dissipation block 224 and in which heat of the second component 222 can be first transferred to the second substrate 21 and then transferred to the first substrate 11 through the second substrate 21, heat dissipation efficiency of the package structure 100 in this embodiment of this application is significantly improved. In addition, because the heat dissipation frame is formed in the first package body 10 and the second package body 20, heat generated in the first package body 10 can be transferred to the second package body 20 through the heat dissipation frame, and heat generated in the second package body 20 can be transferred to the first package body 10 through the heat dissipation frame, that is, the heat in the first package body 10 and the heat in the second package body 20 can be transferred to each other, so that soaking between the first package body 10 and the second package body 20 can be implemented, thereby avoiding heat concentration at a position in the package structure 100, and avoiding damage to the component in the package structure 100 due to temperature concentration.

It should be noted that, in this embodiment of this application, the first heat dissipation block 124, the first connecting rod 123, the second heat dissipation block 224, the second connecting rod 223, the first substrate 11, and the second substrate 21 are connected to form the heat dissipation frame. In addition to a heat conduction function, the heat dissipation frame can have another function, and according to different functions, structures of the heat dissipation frames may also be different.

In this embodiment, the heat dissipation frame has a heat dissipation function. Therefore, only the first heat dissipation block 124 needs to be connected to the first component 122 and the first connecting rod 123, and the second heat dissipation block 224 needs to be connected to the second component 222 and the second connecting rod 223. The first heat dissipation blocks 124 connected to different first components 122 may be disposed separately or may be connected to each other. The second heat dissipation blocks 224 connected to different second components 222 may be disposed separately or may be connected to each other. In this embodiment, a first heat sink 10 is similar to the first package body 10 in the package structure shown in FIG. 4, and is integrated with first heat dissipation blocks 124 connected to different first components 122. A second heat sink 20 is similar to the first package body 10 in the package structure shown in FIG. 5, and second heat dissipation blocks 224 connected to different second components 222 are disposed at intervals.

In this embodiment, the first heat dissipation block 124, the first connecting rod 123, the second heat dissipation block 224, and the second connecting rod 223 are all made of metal materials, and have higher strength than the first package material layer 121 and the second package material layer 221. Therefore, the heat dissipation frame formed by the first heat dissipation block 124, the first connecting rod 123, the second heat dissipation block 224, and the second connecting rod 223 can also be used as a support frame in the package structure 100, to improve strength of the package structure 100 and avoid damage to the package structure 100 due to external pressure.

In this embodiment, the second heat dissipation block 224 is located on a surface that is of the second component 222 and that is away from the second substrate 21, and the second connecting rod 223 is closer to an edge of the second package body 20 than the second component 222. The second heat dissipation block 224 is connected to the second connecting rod 223 to form a frame structure covering the surface that is of the second component 222 and that is away from the second substrate 21. The frame structure can enhance internal strength of the package structure 100, and avoid damage to the package structure 100 caused by an external force.

It may be understood that in some other embodiments of this application, the second connecting rod 223 may be partially closer to an edge of the first package body 10 than the second component 222, or may be partially disposed at any other position on the second substrate 21. For example, the second connecting rod 223 may be disposed between adjacent second components 222 located on the second substrate 21. A quantity of second connecting rods 223 connected to the second substrate 21 in the package structure 100 is increased, so that a channel through which heat of the second component 222 is transferred to the second substrate 21 can be increased, thereby improving heat dissipation efficiency of the second component 222. In addition, a volume occupied by the second connecting rod 223 in the second package layer 22 can be increased, and strength of the package structure 100 can be enhanced.

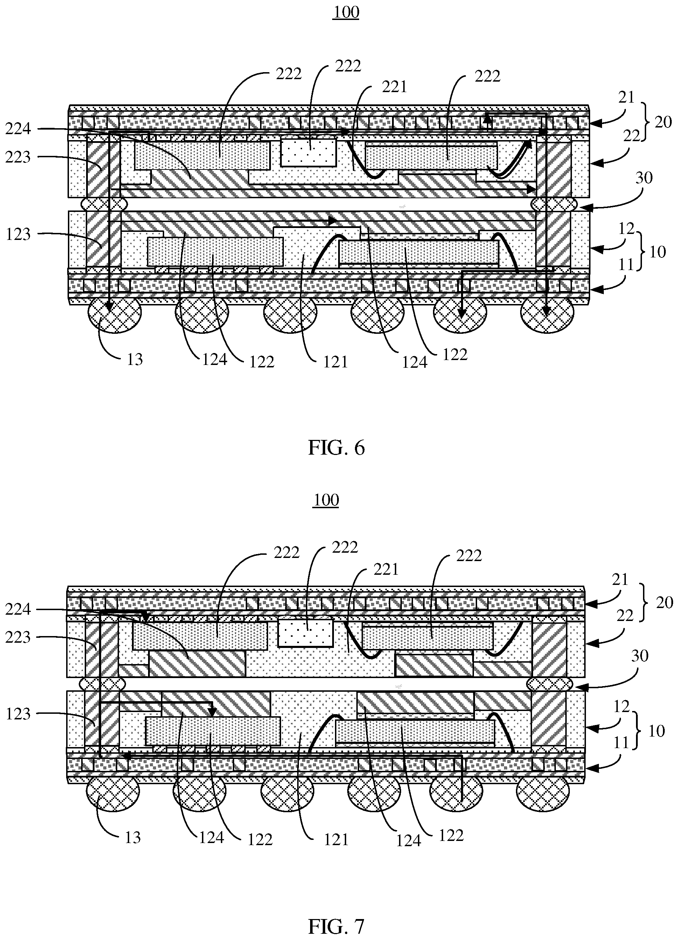

FIG. 6 is a schematic diagram of a structure of the package structure 100 according to another embodiment of this application. In this embodiment, structures of the first package body 10 and the second package body 20 are similar to the structure of the first package body 10 shown in FIG. 4, that is, the second heat dissipation blocks 224 connected to different second components 222 are integrated, in other words, all the second heat dissipation blocks 224 are integrated. In addition, in this embodiment, at least a part of the first connecting rod 123 connected to the first heat dissipation block 124 is electrically connected to the second connecting rod 223 connected to the second heat dissipation block 224, so that the first heat dissipation block 124, the first connecting rod 123, the second heat dissipation block 224, and the second connecting rod 223 are integrated. When at least one first connecting rod 123 or at least one second connecting rod 223 of the integrated first heat dissipation block 124, the first connecting rod 123, the second heat dissipation block 224, and the second connecting rod 223 is grounded, the first heat dissipation block 124, the first connecting rod 123, the second heat dissipation block 224, and the second connecting rod 223 can form a Faraday electromagnetic shield. Specifically, at least one of the first connecting rods 123 or the second connecting rods 223 is grounded, and the integrated first heat dissipation block 124 can be electrically connected to the grounded first connecting rod 123 or the grounded second connecting rod 223, so that the integrated first heat dissipation block 124 is grounded. In other words, the integrated first heat dissipation block 124 can be directly connected to the grounded first connecting rod 123, so that the integrated first heat dissipation block 124 can be grounded. Alternatively, the integrated first heat dissipation block 124 can be connected to the grounded first connecting rod 123 through the connection layer 30, so that the integrated first heat dissipation block 124 can be grounded. In addition, the integrated second heat dissipation block 124 can be electrically connected to the grounded first connecting rod 123 or the grounded second connecting rod 223, so that the integrated second heat dissipation block 124 is grounded. In other words, the integrated second heat dissipation block 124 can be directly connected to the grounded first connecting rod 123, so that the integrated second heat dissipation block 224 can be grounded. Alternatively, the integrated second heat dissipation block 224 can be connected to the grounded first connecting rod 123 through the connection layer 30, so that the integrated second heat dissipation block 224 can be grounded. An arrow in FIG. 6 is a schematic diagram of a direction in which a ground return current generated by a function system of the package structure 100 is returned from a component to a power supply end. In this embodiment, at least two of the external pins 13 on the first substrate 11 are grounded, a ground signal returned by the first component 122 may be transmitted to the grounded external pin 13 through the cable layer 112 of the first substrate 11, or may be transmitted to the grounded external pin 13 through the first heat dissipation block 124 and the first ground rod 123. A ground signal returned by the second component 222 may be transmitted to the second connecting rod 223 through the cable layer 112 of the second substrate 11 or the second heat dissipation block 224, and then transmitted to the grounded external pin 13 sequentially through the second connecting rod 223, the connection part 30, the first connecting rod 123, and the cable layer 112 of the first substrate 11, so that the first heat dissipation block 124, the first connecting rod 123, the second heat dissipation block 224, and the second connecting rod 223 are integrated as a heat dissipation frame to form a low-impedance ground network path, and the path can form a good Faraday electromagnetic shield. In addition, in this embodiment, the first heat dissipation block 124 is located on a surface that is of the first component 122 and that is away from the first substrate 11, the first connecting rod 123 is closer to an edge of the first package body 10 than the first component 122, and the first heat dissipation block 124 is connected to the first connecting rod 123 to form a frame structure covering the surface that is of the first component 122 and that is away from the first substrate 11. The second heat dissipation block 224 is located on a surface that is of the second component 222 and that is away from the second substrate 21, the second connecting rod 223 is closer to an edge of the second package body 20 than the second component 222, and the second heat dissipation block 224 is connected to the second connecting rod 223 to form a frame structure covering the surface that is of the second component 222 and that is away from the second substrate 21. When the first connecting rod 123 or the second connecting rod 223 is grounded through the external pin 13 and the frame structure forms the Faraday electromagnetic shield, electromagnetic interference between the first component 122 in the package structure 100 and the second component 222 in the package structure 100 and electromagnetic interference caused by an external environment of the package structure 100 to the second component 222 in the package structure 100 can be well isolated.

FIG. 7 is a schematic diagram of a structure of the package structure 100 according to another embodiment of this application. In this embodiment, structures of the first package body 10 and the second package body 20 are similar to the structure of the first package body 10 shown in FIG. 5, that is, there are a plurality of first components 122, a plurality of first heat dissipation blocks 124, and a plurality of first connecting rods 123, and the plurality of first heat dissipation blocks 124 are disposed at intervals, different first heat dissipation blocks 124 are connected to different first components 122 and different first connecting rods 123. There are a plurality of second components 222, a plurality of second heat dissipation blocks 224, and a plurality of second connecting rods 223. The plurality of second heat dissipation blocks 224 are disposed at intervals. Different second heat dissipation blocks 224 that are disposed independently are connected to different second components 222 and different second connecting rods 223. An arrow in FIG. 7 is a schematic diagram of a direction in which a ground return current generated by a function system of the package structure 100 is returned from a component to a power supply end. In this embodiment, the external pin 13 that is on the first substrate 11 and connected to the first connecting rod 123 is electrically connected to a power module. That is, a power signal is input into the first connecting rod 123. The power signal input into the first connecting rod 123 is transmitted to the first component 122 through the first heat dissipation block 124 connected to the first connecting rod 123, to supply power to the first component 122, and is transmitted to the second component 222 through the second connecting rod 223 and the second heat dissipation block 224 that are connected to the first connecting rod 123, to supply power to the second component 222. In other words, in this embodiment, in addition to functions of heat dissipation and frame supporting, a heat dissipation frame can also be used as a power network to supply power to the first component 122 and the second component 222.

It may be understood that in some embodiments, the first heat dissipation block 124 and the first connecting rod 123 that are connected to different first components 122 may be connected to different external pins 13. The second heat dissipation block 224 and the second connecting rod 223 that are connected to different second components 222 may be connected to different external pins 13. Different external pins 13 are connected to different external modules, so as to provide, through different first heat dissipation blocks 124 and different second heat dissipation blocks 224, different signals for components connected to the first heat dissipation blocks 124 and the second heat dissipation blocks 224. For example, a part of the external pins 13 are electrically connected to the antenna module 200, so that the first component 122 or the second component 222 connected to the external pins 13 communicates with the antenna module 200. A part of the external pins 13 are electrically connected to the sensor module 400, so that the first component 122 or the second component 222 connected to the external pins 13 communicates with the sensor module 400. In this embodiment, the first connecting rod 123, the first heat dissipation block 124, the second connecting rod 223, and the second heat dissipation block 224 are disposed in the package structure 100. A signal is provided for the first component 122 through the first connecting rod 123 and the first heat dissipation block 124, and a signal is provided for the second component 222 through the second connecting rod 223 and the second heat dissipation block 224, to increase a transmission path of the signal in the package structure 100, so that the signal can be distributed to different first components 122 or different second components 222 through a substrate, and in addition, the signal can be further distributed to different first components 122 or different second components 222 through the first connecting rod 123, the first heat dissipation block 124, the second connecting rod 223, and the second heat dissipation block 224, that is, the signal can be redistributed in the package structure 100 through the first connecting rod 123, the first heat dissipation block 124, the second connecting rod 223, and the second heat dissipation block 224.

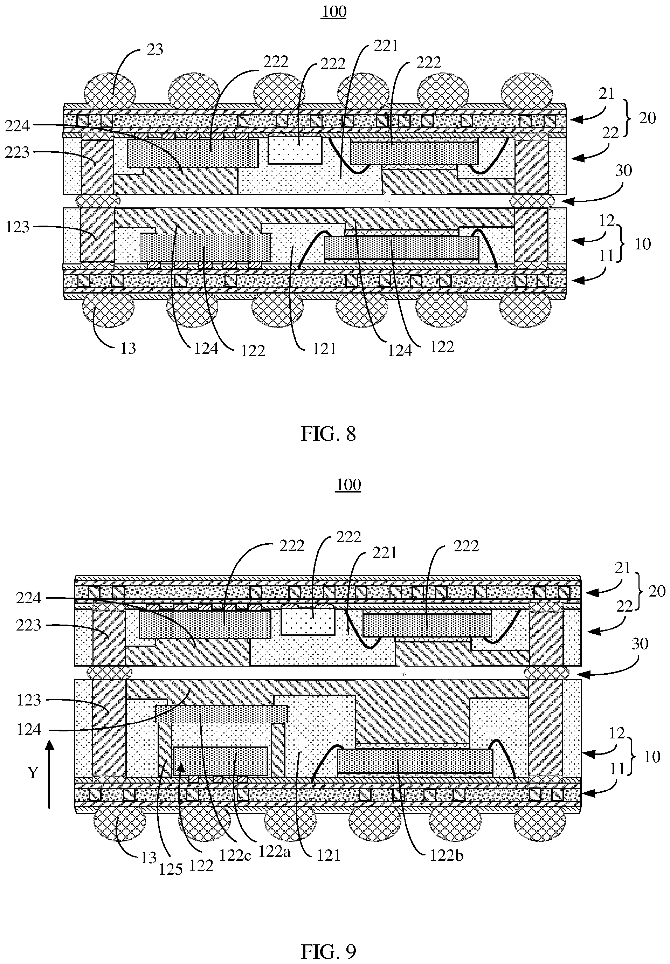

FIG. 8 is a schematic diagram of a structure of a package structure according to some other embodiments of this application. A difference between this embodiment and the embodiment shown in FIG. 3 lies in that an external pin 23 is disposed on a surface that is of the second substrate 21 and that is away from the second package layer 22, and the external pin 23 is configured to electrically connect to an external structure of the package structure 100. The external pin 23 is connected to the cable layer 212, so that the second substrate 21 can be electrically connected to the external structure (for example, function modules of the electronic apparatus 1000) of the package structure 100 through the external pin 23, and a structure (for example, the second component 222) that is in the package structure 100 and that is electrically connected to the second substrate 21 is electrically connected to the external structure of the package structure 100. Both the second heat dissipation block 224 and the second connecting rod 223 can conduct electricity, and the second connecting rod 223 is connected to the second substrate 21. Therefore, in some embodiments, a signal may be input into the second connecting rod 223 through the second substrate 21, and the signal can be transmitted to the second component 222 through the second connecting rod 223 and the second heat dissipation block 224. In this embodiment, the second connecting rod 223 is connected to the external pin 23 of the second substrate 21 through the cable layer 112 on the second substrate 21, and the external pin 23 is connected to the external structure of the package structure 100. The external structure of the package structure 100 communicates with the corresponding second component 222 sequentially through the external pin 23, the second substrate 21, the second connecting rod 223, and the second heat dissipation block 224. Alternatively, the external structure of the package structure 100 is connected to the external pin 13 of the first substrate 11. The external structure of the package structure 100 communicates with the corresponding second component 222 sequentially through the external pin 13, the first substrate 11, the first connecting rod 123, the second connecting rod 223, and the second heat dissipation block 224.

Because the second connecting rod 223 is electrically connected to the first connecting rod 123, a signal transmitted through the external pin 23 may also be transmitted to the first component 122 sequentially through the second connecting rod 223, the first connecting rod 123, and the first heat dissipation block 124, to implement communication between the first component 122 and the external structure of the package structure 100.

In this embodiment of this application, the external pin 13 is disposed on a surface that is of the first substrate 11 and that is away from the first package layer 12, and the external pin 23 is disposed on a surface that is of the second substrate 21 and that is away from the second package layer 22, so that a signal may be transmitted through the first substrate 11, or may be transmitted through the second substrate 21. Compared with a manner in which the external pin 13 is disposed only on a single side (for example, the first substrate 11), a quantity of external pins 13 is increased, so that density of an output signal in the entire package structure 100 can be increased, a quantity of components in the package structure 100 is increased, and a quantity of integrated components in the package structure 100 is increased, so as to facilitate miniaturization and improvement of function diversity of the electronic apparatus 1000. In addition, compared with the manner in which the external pin 13 is disposed only on a single side, the component in the package structure 100 not only may be connected to the external pin 13 on the first substrate 11, but also may be connected to the external pin 23 on the second substrate 21. Therefore, flexibility of disposing components and cables in the package structure 100 can be improved, and a design of the package structure 100 can be simplified.

FIG. 9 is a schematic diagram of a structure according to another embodiment of this application. A difference between this embodiment and the embodiment shown in FIG. 3 lies in that: in this embodiment, the first components 122 at the first package layer 12 are stacked in a thickness direction of the package structure 100, and the first heat dissipation block 124 is in contact with the first component 122 that is farthest from the first substrate 11 and that is in the stacked first components 122. The thickness direction of the package structure 100 is a direction perpendicular to a surface that is of the first substrate 11 and that faces the first package layer 12, that is, a Y direction shown in FIG. 9.

In this embodiment, three first components 122 are packaged at the first package layer 12, and the three first components 122 are respectively a first component 122a, a first component 122b, and a first component 122c. Both the first component 122a and the first component 122b are disposed on the first substrate 11 and are directly connected to the first substrate 11. The first component 122a and the first component 122b are stacked in the thickness direction of the package structure 100. In other words, the first component 122c is stacked on a surface that is of the first component 122a and that is away from the first substrate 11. In addition, in this embodiment, the first component 122c is connected to the first substrate 11 through a connecting rod 125, to implement an electrical connection between the first component 122c and the first substrate 11, and can transfer a part of heat generated by the first component 122c to the first substrate 11 through the connecting rod 125. In this embodiment, the first heat dissipation block 124 is in contact with a surface that is of the first component 122c and that is away from the first substrate 11. A part of heat generated by the first component 122c during operating is transferred to the first substrate 10 through the first heat dissipation block 124 and the first connecting rod 123, and then is transferred out.

In some embodiments, one end that is of the connecting rod 125 and that is away from the first component 122c is connected to the first component 122a, so that the first component 122c is electrically connected to the first component 122a, and a part of heat of the first component 122a can be transferred to the first heat dissipation block 124 through the first component 122c, or a part of heat generated by the first component 122c can be transferred to the first substrate 11 through the first component 122a.

It may be understood that a quantity of first components 122 stacked at the first package layer 12 is not limited in this application, and three, four, or more first components 122 may be stacked based on an actual requirement.

In this embodiment of this application, a part of the first components 122 at the first package layer 12 are stacked in the thickness direction of the package structure 100, so that the components are stacked in the thickness direction of the package structure 100, thereby increasing density of the components in the package structure 100. When a same quantity of first components 122 are packaged at the first package layer 12, because a part of the first components 122 are stacked in the thickness direction of the package structure 100, compared with the package structure 100 (the package structure 100 shown in FIG. 3) in which all the first components 122 are directly connected to the first substrate 11, in this package structure, a size of the first substrate 11 can be reduced, and an area occupied by the package structure 100 can be reduced.

It may be understood that, in some other embodiments of this application, the second components 222 may alternatively be stacked in the thickness direction of the package structure 100, to further increase the density of the components in the package structure 100, and reduce the area occupied by the package structure 100 by using space in the thickness direction of the package structure 100. When the package structure 100 is applied to the electronic apparatus 1000, because the area occupied by the package structure 100 is relatively small, a size of the electronic apparatus 1000 can be reduced, thereby implementing miniaturization of the electronic apparatus 1000. In addition, because the density of the components in the package structure 100 is increased, compared with the package structure 100 shown in FIG. 3, when a size of the package structure 100 is the same, more components can be packaged in the package structure 100, thereby facilitating improvement of function diversity of the electronic apparatus 1000.

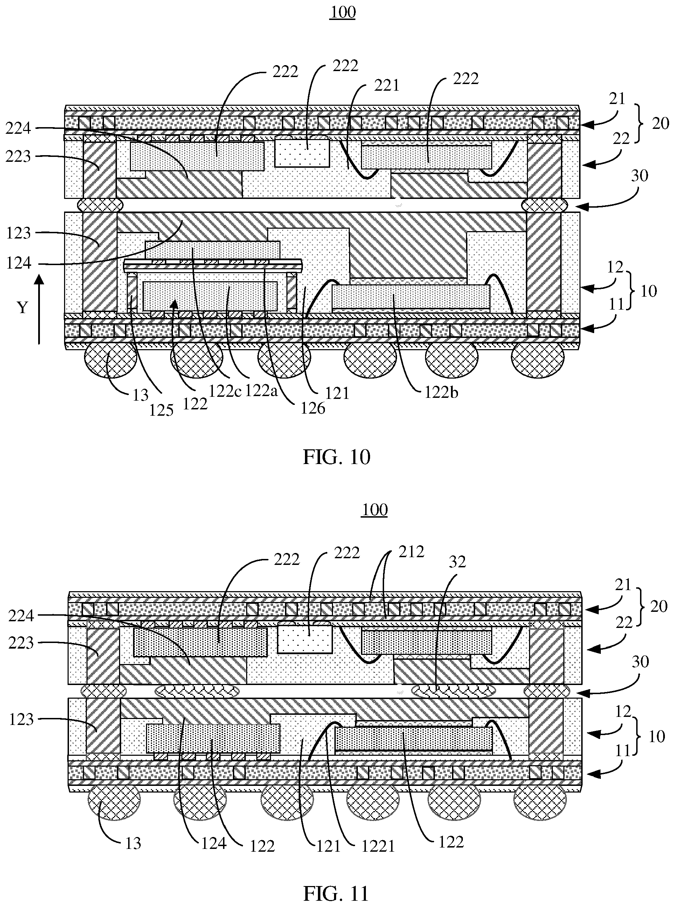

FIG. 10 is a schematic diagram of the package structure 100 according to some other embodiments of this application. A difference between this embodiment and the embodiment shown in FIG. 9 lies in that: a third substrate 126 is further disposed at the first package layer 12, and a connecting rod 124 is supported between the third substrate 126 and the first substrate 11, and is electrically connected to the first substrate 11 and the third substrate 126. The first component 122 may be disposed on a surface that is of the third substrate 126 and that faces the first substrate 11 and/or a surface that is of the third substrate 126 and that is away from the first substrate 11, to fully use space in a thickness direction of the package structure 100. In addition, a plurality of (two or more) first components 122 may be disposed on the third substrate 126, and electrical connections between at least a part of the first components 122 disposed on the third substrate 126 are implemented by using the third substrate 126. In this embodiment, the first component 122c is supported, by using the connecting rod 125, on a surface that is of the first substrate 11 and that faces the first package layer 12. Space can be formed between the first component 122c and the first substrate 11 to dispose the first component 122a, so that space in the thickness direction of the package structure 100 is fully used, and density of components in the package structure 100 is improved.

In some embodiments, the third substrate 126 may also be disposed at the second package layer 22. The third substrate 126 is supported between the second substrate 21 and the third substrate 126 by using the connecting rod 125, and the second substrate 21 is electrically connected to the third substrate 126. The second component 222 is disposed on a surface that is of the third substrate 126 and that faces the second substrate 21 and/or a surface that is of the third substrate 126 and that is away from the second substrate 21. In this embodiment, a plurality of second components 222 may be disposed on the third substrate 126, and electrical connections between at least a part of the second components 222 disposed on the third substrate 126 are implemented by using the third substrate 126. In this embodiment, the third substrate 126 is disposed at the first package layer 12, so that the first component 122 can be disposed on both opposite surfaces of the third substrate 126. In addition, the third substrate 126 is disposed at the second package layer 22, so that the second component 222 can be disposed on both opposite surfaces of the third substrate 126. In this way, space in the thickness direction of the package structure 100 is fully used, and density of components in the package structure 100 is improved.

It may be understood that in some embodiments, the third substrate 126 may be disposed only at the second package layer 22, and no third substrate 126 is disposed at the first package layer 12. In other words, the second components 222 at the second package layer 22 are stacked in the thickness direction of the package structure 100. All first components 122 in the first package layer 12 are disposed on the first substrate 11.

In some embodiments, one end of the connecting rod 124 is connected to the third substrate 126, and the other end may be connected to the first component 122 that is stacked on the third substrate 126 in the thickness direction and that is closest to the third substrate 126. Alternatively, one end of the connecting rod 125 is connected to the third substrate 126, and the other end may be connected to the first component 122 that is stacked on the third substrate 126 in the thickness direction and that is closest to the third substrate 126.

FIG. 11 shows another package structure 100 according to this application. A difference between the package structure 100 in this embodiment and the package structure 100 in the embodiment shown in FIG. 3 lies in that the connection layer 30 further includes a thermal conductive block 32. The thermal conductive block 32 is located between a surface that is of the first heat dissipation block 124 and that exposes from the first package material layer 121 and a surface that is of the second heat dissipation block 224 and that exposes from the second package material layer 221. The thermal conductive block 32 is connected between the first heat dissipation block 124 and the second heat dissipation block 224, and is configured to: implement heat transfer between the second heat dissipation block 224 and the second package body 20, improve a heat transfer speed between the first package body 10 and the second package body 20, and improve soaking efficiency in the package structure 100. In addition, the thermal conductive block 32 is disposed between the surface that is of the first heat dissipation block 124 and that exposes from the first package material layer 121 and the surface that is of the second heat dissipation block 224 and that exposes from the second package material layer 221, in other words, the thermal conductive block 32 is added between the first package body 10 and the second package body 20. Therefore, connection fixing strength between the first package body 10 and the second package body 20 can be further improved. There may be one or more first thermal conductive blocks 32, and the plurality of first thermal conductive blocks 32 are disposed at intervals. The first thermal conductive block 32 may be a thermal conductive structure such as a solder joint or a thermal conductive adhesive layer. In this embodiment, the first thermal conductive block 32 and the connection sub-block 31 are the same, and both are solder joints, so that a manufacturing process is simplified.

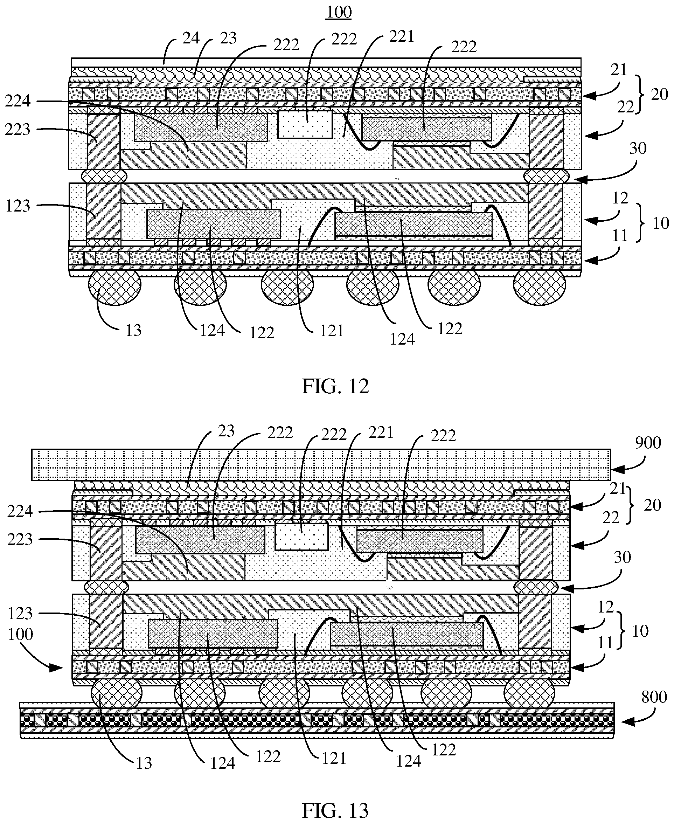

FIG. 12 shows another package structure 100 according to this application. A difference between this embodiment and the embodiment shown in FIG. 3 lies in that: a surface that is of the second package body 20 and that is away from the first package body 10 is covered with a thermal conductive adhesive layer 23, and the thermal conductive adhesive layer 23 is configured to transfer heat. In this embodiment, the second substrate 21 of the second package body 20 is located on a surface that is away from the second package layer 22 and that is away from the first package body 10, and the thermal conductive adhesive layer 23 is located on a surface that is of the second substrate 21 and that is away from the second package layer 22. In addition, in this embodiment, the thermal conductive adhesive layer 23 covers a surface that is of the second substrate 21 and that is away from the second package body 20. The thermal conductive adhesive layer 23 can be configured to paste the package structure 100 onto a heat dissipation structure in the electronic apparatus 1000, so that the package structure 100 is fastened in the electronic apparatus 1000, and heat can be transferred to the heat dissipation structure through the second substrate 21 and the thermal conductive adhesive layer 23, thereby improving heat dissipation efficiency of the package structure 100.

In this embodiment, a part of positions of the insulation layer 111 on a side that is of the second substrate 21 and that is away from the second package layer 22 is hollowed out, to expose a part of the cable layer 112. When the thermal conductive adhesive layer 23 covers the surface that is of the second substrate 21 and that is away from the second package layer 22, the thermal conductive adhesive layer 22 can be in direct contact with the exposed cable layer 112. Thermal conductivity of the thermal conductive adhesive layer 23 is higher than that of the insulation layer 111, so that heat generated by the components in the package structure 100 in this embodiment during operating can be more quickly transferred out through the thermal conductive adhesive layer 23. It may be understood that in some embodiments of this application, the insulation layer 111 on the side that is of the second substrate 21 and that is away from the second package layer 22 may be directly removed, and the thermal conductive adhesive layer 23 is covered, so that heat transferred at the cable layer 112 is transferred out as soon as possible. It should be noted that the thermal conductive adhesive layer 23 is made of an insulating and thermal conductive material.

In some embodiments, a release film 24 is disposed on a surface that is of the thermal conductive adhesive layer 23 and that is away from the second package layer 22. When the package structure 100 is fastened to the middle frame 900, the thermal conductive adhesive layer 23 can be attached to the middle frame 900 by directly removing the release film 24. Operations are simple.

FIG. 13 is a schematic diagram of a partial cross section of the electronic apparatus 1000 in which the package structure 100 according to the embodiment shown in FIG. 12 is disposed. In this embodiment, the electronic apparatus 1000 includes the middle frame 900 and the mainboard 800. The middle frame 900 is configured to implement heat dissipation of the electronic apparatus 1000. The package structure 100 is disposed between the mainboard 800 and the middle frame 900. The first substrate 11 of the package structure 100 is connected to the mainboard 800 through the external pin 13, so that the package structure 100 is fastened and electrically connected to the first substrate 11. The thermal conductive adhesive layer 23 of the package structure 100 is in contact with the middle frame 900, to fasten the package structure 100 and the middle frame 900. In this embodiment, heat generated by a component in the package structure 100 during operating may be transferred to the first substrate 11, and is transferred to the mainboard 800 through the external pin 13. The heat is distributed, through the mainboard 800, to each position of the mainboard 800 and each operating module connected to the mainboard 800, to avoid damage caused by heat concentration at a position of the package structure 100. In addition, the heat generated by the component in the package structure 100 during operating may be transferred to the second substrate 21, then transferred to the middle frame 900 through the thermal conductive adhesive layer 23, and dissipated out of the electronic apparatus 1000 through the middle frame 900.

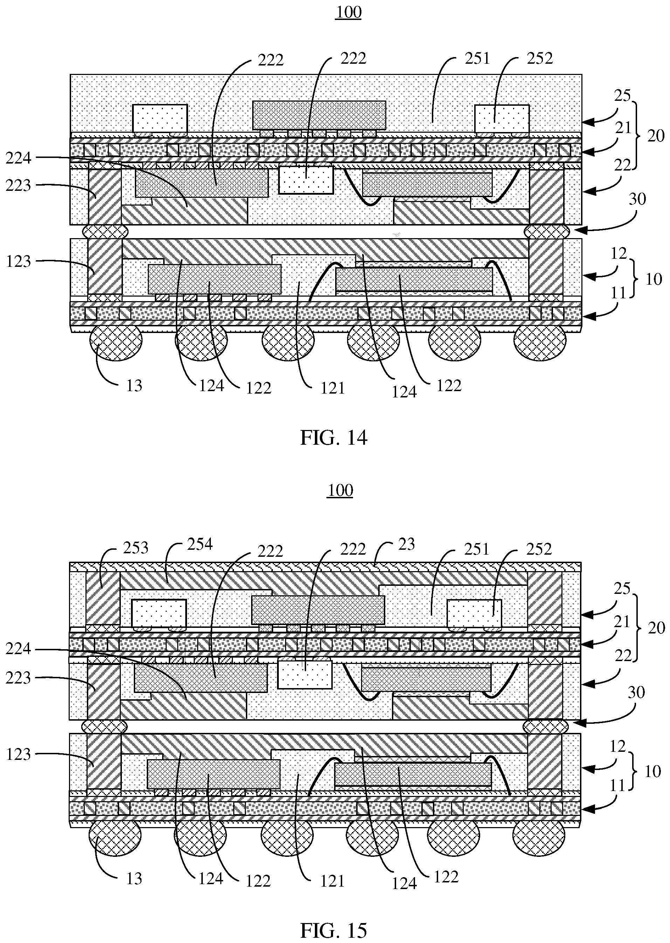

FIG. 14 is a schematic diagram of a structure of the package structure 100 according to another embodiment of this application. A difference between this embodiment and the embodiment shown in FIG. 3 lies in that: the second package body 20 further includes a third package layer 25. The third package body 25 is packaged on a surface that is of the second substrate 21 and that is away from the second package layer 22. The third package layer 25 includes a third package material layer 251 and one or more third components 252 embedded in the third package material layer 251. Each third component 252 is electrically connected to the second substrate 21. In this embodiment, there are a plurality of third components 252 embedded in the third package material layer 251.

In this embodiment, each third component 252 is disposed on the second substrate 21, and is directly connected to the second substrate 21, that is, a pin of the third component 252 is directly connected to the second substrate 21. It may be understood that in some embodiments of this application, the third component 252 may alternatively be indirectly connected to the second substrate 21 through a connecting rod. Alternatively, in some embodiments, the third components 252 are stacked in a thickness direction of the package structure 100. A part of third components 252 in the stacked third components 252 are directly electrically connected to the second substrate 21, and another part of third components 252 are indirectly electrically connected to the second substrate 21 through the third components 252 that are directly connected to the second substrate 21, or are indirectly electrically connected to the second substrate 21 through connecting rods.

In this embodiment, the third package layer 25 is packaged on the surface that is of the second substrate 21 and that is away from the second package layer 22, that is, package layers are disposed on both opposite surfaces of the second substrate 21, so that a quantity of components stacked in the thickness direction of the package structure 100 is increased, an area occupied by the package structure 100 applied to the electronic apparatus 1000 is reduced, and a quantity of components in the package structure 100 is increased, so as to facilitate miniaturization and versatility of the electronic apparatus 1000.

FIG. 15 is a schematic diagram of a structure of the package structure 100 according to another embodiment of this application. In this embodiment, the third package layer 25 further includes a plurality of third connecting rods 253 and one or more third heat dissipation blocks 254. All the third connecting rods 253 and all the third heat dissipation blocks 254 are embedded in the third package material layer 251. One end of each third connecting rod 253 is connected to the second substrate 21, and the other end extends to a surface that is of the third package layer 25 and that is away from the second substrate 21. Each third heat dissipation block 254 is connected to at least one third connecting rod 253, and each third heat dissipation block 254 is connected to one or more third components 252, so that the third component 252 and the third connecting rod 253 can be connected through the third heat dissipation block 254, and heat of the third component 252 can be transferred to the third connecting rod 253 through the third heat dissipation block 254.

In this embodiment, a part of heat generated by the third component 252 can be directly transferred to the second substrate 21, and a part of heat can be transferred to the second substrate 21 sequentially through the third heat dissipation block 254 and the third connecting rod 253, thereby increasing a heat transfer path of the third component 252, so that heat generated by the third component 252 during operating can be relatively quickly transferred to another position in the package structure 100, and heat concentration is avoided. In addition, heat generated by the second substrate 21 can be transferred to the first substrate 11 sequentially through the second connecting rod 223 and the first connecting rod 123, and transferred to the outside of the package structure 100 through the external pin 13 of the first substrate 11, to implement heat dissipation. It may be understood that in this embodiment, heat generated by the second component 222 at the second package layer 22 and the first component 122 at the first package layer 12 can also be transferred to the third package layer 25, to implement soaking in the package structure 100, avoid heat accumulation at a position in the package structure 100, and avoid damage to the package structure due to heat accumulation.

In some embodiments of this application, the third package material layer 251 exposes from a surface that is of the third heat dissipation block 254 and that is away from the second substrate 21, to simplify a production process. In some embodiments, a side that is of the third package layer 25 and that is away from the second substrate 21 is covered with a thermal conductive adhesive layer 23. The third package material layer 251 exposes from the surface that is of the third connecting rod 253 and that is away from the third substrate 126. Therefore, the third connecting rod 253 can be in contact with the thermal conductive adhesive layer 23, to transfer a part of heat in the package structure 100 to the thermal conductive adhesive layer 23 through the third connecting rod 253. When the package structure 100 is disposed in the electronic apparatus 1000, the thermal conductive adhesive layer 23 can fasten the package structure 100 to a heat dissipation structure in the electronic apparatus 1000, and heat generated in the package structure 100 can be transferred to the heat dissipation structure in the electronic apparatus 1000 through the thermal conductive adhesive layer 23.

In this embodiment, the third package material layer 251 exposes from the surface that is of the third heat dissipation block 254 and that is away from the second substrate 21, and when the thermal conductive adhesive layer 23 covers the side that is of the third package layer 25 and that is away from the second substrate 21, the third heat dissipation block 254 is in direct contact with the thermal conductive adhesive layer 23, so that heat generated by the third component 252 can be more quickly transferred to the thermal conductive adhesive layer 23, and transferred to the heat dissipation structure outside the package structure 100 through the thermal conductive adhesive layer 23, thereby improving heat dissipation efficiency of the package structure 100.

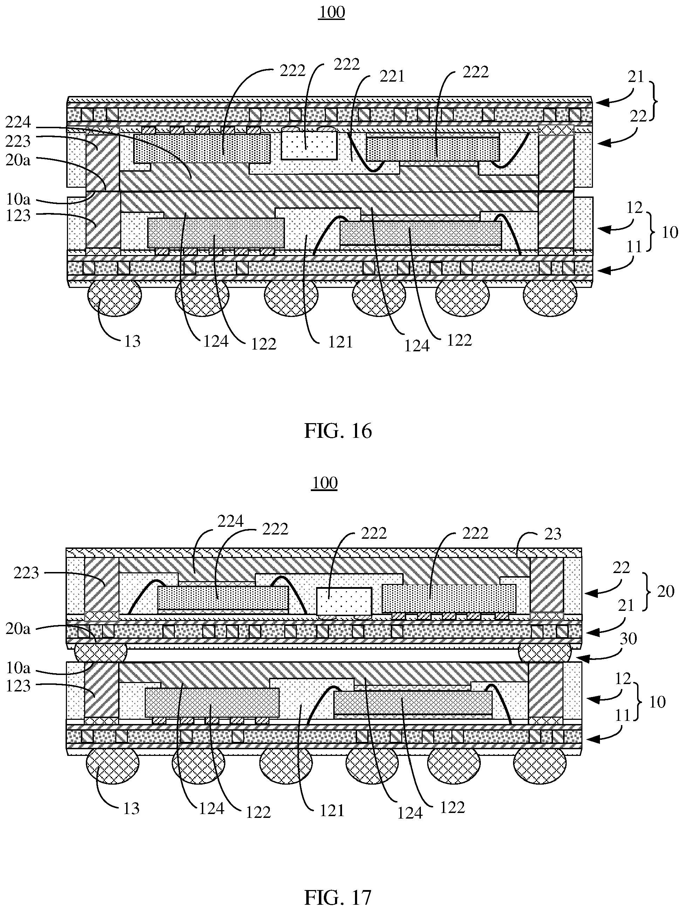

FIG. 16 is a schematic diagram of a structure of the package structure 100 according to another embodiment of this application. A difference between this embodiment and the embodiment shown in FIG. 3 lies in that: the first package material layer 121 exposes from a surface that is of the first heat dissipation block 124 and that is away from the first substrate 11, and the second package layer 22 exposes from a surface that is of the second heat dissipation block 224 and that is away from the second substrate 21. A surface that is of the first heat dissipation block 124 and that exposes from the first package layer 12 is in contact with a surface that is of the second heat dissipation block 224 and that exposes from the second package layer 22, and the first heat dissipation block 124 and the second heat dissipation block 224 form an integrated structure. In this embodiment, that the first heat dissipation block 124 and the second heat dissipation block 224 form an integrated structure means that the first heat dissipation block 124 and the second heat dissipation block 224 can use an intermolecular force to fixedly connect the first package body 10 and the second package body 20. Specifically, the surface that is of the first heat dissipation block 124 and that exposes from the first package layer 12 is in contact with the surface that is of the second heat dissipation block 224 and that exposes from the second package layer 22, and operations such as heating and pressurization are performed on a contact interface, so that an intermolecular force is generated between the surface that is of the first heat dissipation block 124 and that exposes from the first package layer 12 and the surface that is of the second heat dissipation block 224 and that exposes from the second package layer 22, and the first heat dissipation block 124 and the second heat dissipation block 224 form an integrated structure. In this embodiment, a surface that is of the first connecting rod 123 and that exposes from the first package material layer 121 is in contact with a surface that is of the second connecting rod 223 and that exposes from the second package material layer 221, and is fastened by using an intermolecular force between the first connecting rod 123 and the second connecting rod 223.

In this embodiment, the first connecting rod 123, the second connecting rod 223, the first heat dissipation block 124, and the second heat dissipation block 224 are all made of metal copper. In this embodiment, the first package body 10 and the second package body 20 are stacked, the surface that is of the first heat dissipation block 124 and that exposes from the first package layer 12 is in contact with the surface that is of the second heat dissipation block 224 and that exposes from the second package layer 22, the surface that is of the first connecting rod 123 and that exposes from the first package material layer 121 is in contact with the surface that is of the second connecting rod 223 and that exposes from the second package material layer 221, and then processing such as heating and pressurization is performed on the package structure 100, so that an intermolecular force of copper-copper bonding is generated between the first heat dissipation block 124 and the second heat dissipation block 224, and the first package body 10 and the second package body 20 are fastened together in a bonding manner. In addition, an intermolecular force of copper-copper bonding is also generated between the first connecting rod 123 and the second connecting rod 223, to implement fastening and electrical connection between the first connecting rod 123 and the second connecting rod 223.

In some embodiments, a surface that is of the first heat dissipation block 124 and that is away from the first substrate 123 slightly exposes from a surface that is of the first package material layer 121 and that is away from the first substrate 123, and a surface that is of the second heat dissipation block 224 and that is away from the second substrate 223 slightly exposes from a surface that is of the second package material layer 221 and that is away from the second substrate 223, so that when processing such as heating and pressurization is performed on the package structure 100, the first package material layer 121 and the second package material layer 221 do not affect close contact between the first heat dissipation block 124 and the second heat dissipation block 224, thereby avoiding impact caused by an intermolecular force between the first heat dissipation block 124 and the second heat dissipation block 224.

In this embodiment, the first connecting rod 123, the second connecting rod 223, the first heat dissipation block 124, and the second heat dissipation block 224 are made of a same material, the first heat dissipation block 124 is connected to the first connecting rod 123, and the second heat dissipation block 224 is connected to the second connecting rod 223. Therefore, the first connecting rod 123 may not be disposed opposite to the second connecting rod 223, but correspond to a position of the first heat dissipation block 124. That is, when the first package body 10 and the second package body 20 are stacked, one end that is of the first connecting rod 123 and that exposes from the first package material layer 121 is in contact with the second heat dissipation block 224, so that a signal transmitted in the first connecting rod 123 can be transmitted to the second connecting rod 223 through the second heat dissipation block 224. Alternatively, in some embodiments, when the first package body 10 and the second package body 20 are stacked, one end that is of the second connecting rod 223 and that exposes from the second package material layer 221 may be in contact with the first heat dissipation block 124, so that a signal transmitted in the first connecting rod 123 can be transmitted to the second connecting rod 223 through the first heat dissipation block 124. When the first connecting rod 123 is in contact with the second heat dissipation block 224, the first connecting rod 123 and the second heat dissipation block 224 can also generate an intermolecular force under a specific condition, so that the first package body 10 is fastened and electrically connected to the second package body 20. Alternatively, when the second connecting rod 223 is in contact with the first heat dissipation block 124, the second connecting rod 223 and the first heat dissipation block 124 can also generate an intermolecular force under a specific condition, so that the first package body 10 is fastened and electrically connected to the second package body 20.

FIG. 17 shows another package structure 100 according to this application. A difference between this embodiment and the embodiment shown in FIG. 3 lies in that the second substrate 21 is located on a side that is of the second package layer 22 and that faces the first substrate 11, and the first connecting rod 123 is electrically connected to the second substrate 21. In this embodiment, a solder pad connected to the cable layer 112 of the second substrate 21 is disposed on the second substrate 21, and a surface that is of the first connecting rod 123 and that exposes from the first package material layer 121 is connected to the solder pad on the second substrate 21 through the connection layer 30. In this way, the first connecting rod 123 is electrically connected to a substrate. In this embodiment, the surface that is of the first connecting rod 123 and that exposes from the first package material layer 121 is a first output terminal 10a of the first package body 10, and the solder pad that is on the second substrate 21 and that is electrically connected to the first connecting rod 123 is the second connection terminal 20a.

In some embodiments, a surface that is of the second package layer 22 and that is away from the second substrate 21 is covered with the thermal conductive adhesive layer 23. In this embodiment, the second package material layer 221 exposes from a surface that is of the second heat dissipation block 224 and that is away from the second substrate 21, and the second package material layer 221 exposes from a surface that is of the second connecting rod 223 and that is away from the second substrate 21. When covering the second package layer 22, the thermal conductive adhesive layer 23 can be in direct contact with the second heat dissipation block 224 and the second connecting rod 223, so that heat transferred on the second heat dissipation block 224 and heat transferred to the second connecting rod 223 can be quickly dissipated through the thermal conductive adhesive layer 23, to improve heat dissipation efficiency of the package structure 100.

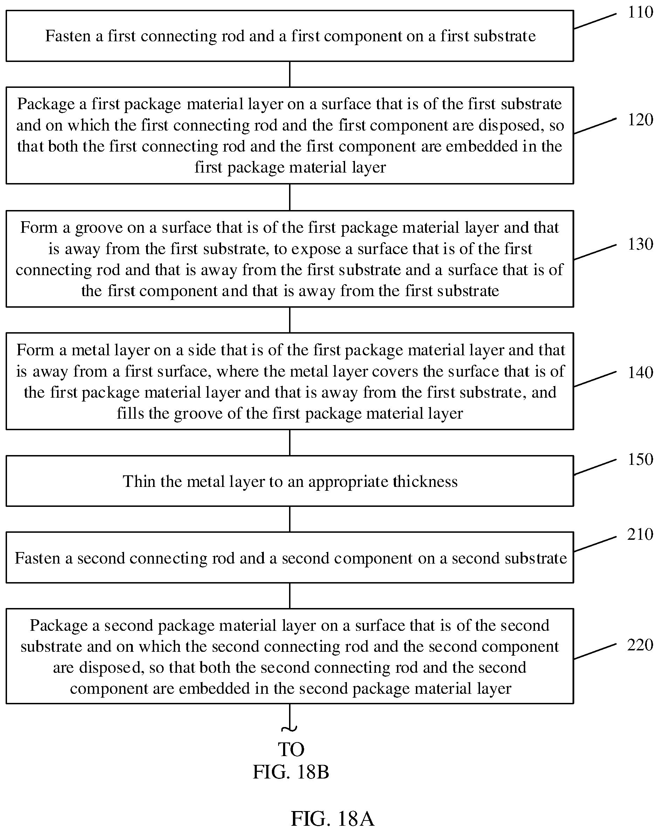

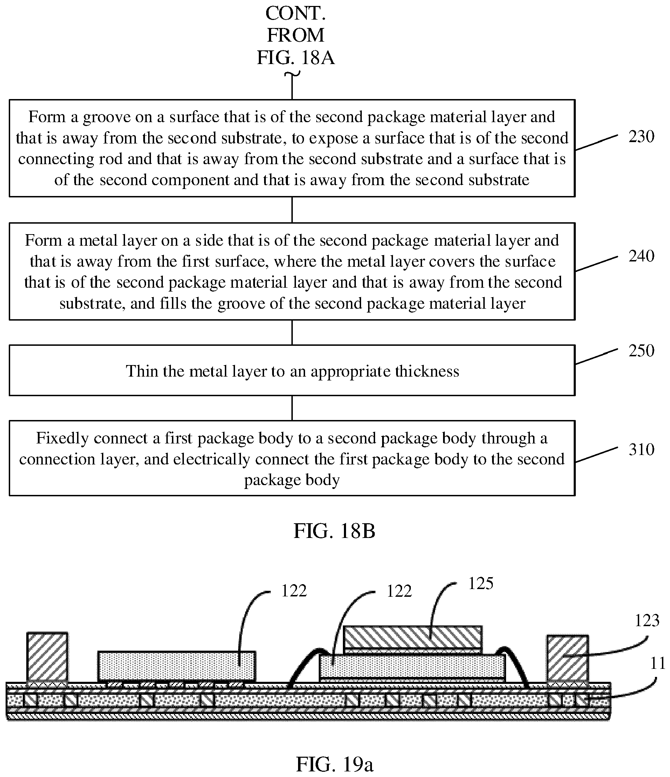

This application further provides a method for preparing the package structure 100. FIG. 18A and FIG. 18B are a flowchart of a process of preparing the package structure 100 according to the embodiment shown in FIG. 3. A method for forming the package structure 100 is to first form the first package body 10 and the second package body 20, and then connect the first package body 10 and the second package body 20 through the connection layer 30, to implement a fixed connection and an electrical connection between the first package body 10 and the second package body 20. A method for forming the first package body 10 may include:

Step 110: Refer to FIG. 19a. Fasten the first connecting rod 123 and the first component 122 on the first substrate 11. In some other embodiments of this application, when the first components 122 at the first package layer 12 are stacked in a thickness direction, step 110 is fastening the first connecting rod 123 and a part of the first components 122 on the first substrate 11.

In this embodiment, the first connecting rod 123 may be fastened to the first substrate 11 through conductive adhesive sticking, solder welding, or the like, so that the first connecting rod 123 is fastened and electrically connected to the first substrate 11. The first component 122 may be fastened to the first substrate 11 through surface mounting, bonding, or the like, so that the first component 122 is fastened and electrically connected to the first substrate 11.

In some embodiments, when the first component 122 is a chip, and the chip is fastened to the first substrate 11 in a formal mounting manner, in other words, a pin of the chip is located on a surface that is of the chip and that is away from the first substrate 11, and before the chip is fastened and electrically connected to the first substrate 11 through the bonding wire 1221, a metal sheet 125 needs to be pasted on the surface that is of the chip and that is away from the first substrate 11 in a manner of adhesive or welding. In this embodiment, a material of the metal sheet 125 is the same as materials of the first connecting rod 123 and the first heat dissipation block 124. It may be understood that in some embodiments, the material of the metal sheet 125 may alternatively be different from the material of the first connecting rod 123 or the first heat dissipation block 124.

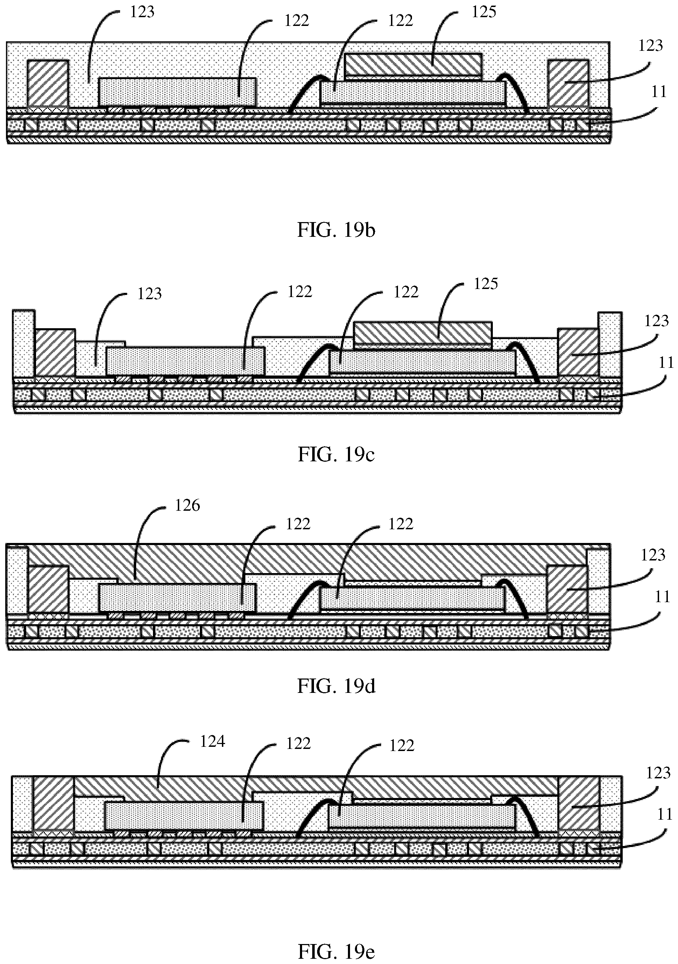

Step 120: Refer to FIG. 19b. Package the first package material layer 121 on a surface that is of the first substrate 11 and on which the first connecting rod 123 and the first component 122 are disposed, so that both the first connecting rod 123 and the first component 122 are embedded in the first package material layer 121. The first package material layer 121 is a package material such as resin.

Step 130: Refer to FIG. 19c. Form a groove on a surface that is of the first package material layer 121 and that is away from the first substrate 11, to expose a surface that is of the first connecting rod 123 and that is away from the first substrate 11 and a surface that is of the first component 122 and that is away from the first substrate 11. When a metal sheet is disposed on the surface that is of the first component 122 and that is away from the first substrate 11, in step 130, a groove is formed at the first package material layer 121 to expose the metal sheet disposed on the surface of the first component 122.

In this embodiment, the groove is formed in a laser grooving manner, and a depth of laser grooving may be controlled based on a specific requirement. When the chip is fastened in the formal mounting manner, an active surface of the chip is away from the first substrate 11. During laser grooving, because a position of the grooving is above the chip, to avoid damage to the chip due to insufficient control precision of the grooving depth, the metal sheet is formed on a surface that is of the formal chip and that is away from the first substrate 11, and the laser grooving is performed until the metal sheet 125 is exposed, so that damage to the chip caused by laser grooving can be avoided. It may be understood that in some other embodiments of this application, the groove may alternatively be formed in a manner of mold pressing or the like.

Step 140: Refer to FIG. 19d. Form a metal layer 126 on a side that is of the first package material layer 121 and that is away from a first surface, where the metal layer 126 covers the surface that is of the first package material layer 121 and that is away from the first substrate 11, and fills the groove formed in step 130.

Step 150: Refer to FIG. 19e. Thin the metal layer 126 to an appropriate thickness, to obtain the first heat dissipation block 124 connecting the first component 122 and the first connecting rod 123. In this embodiment, a surface that is of the thinned metal layer 126 and that is away from the first substrate 11 is a plane, to facilitate processing in a subsequent step. It may be understood that in some embodiments, step 150 may not exist.

A method for forming the second package body 20 is similar to the method for forming the first package body 10, and includes:

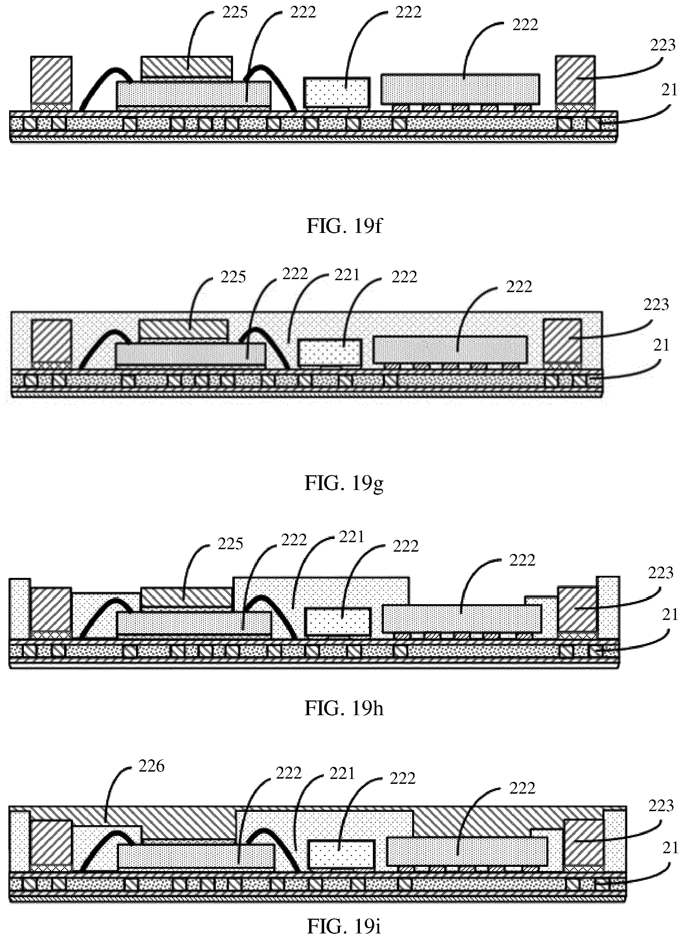

Step 210: Refer to FIG. 19f. Fasten the second connecting rod 223 and the second component 222 on the second substrate 21. In some other embodiments of this application, when the second components 222 at the first package layer 12 are stacked in a thickness direction, step 110 is fastening the second connecting rod 223 and a part of the second components 222 on the second substrate 21.

In this embodiment, the second connecting rod 223 may be fastened to the second substrate 21 through conductive adhesive sticking, solder welding, or the like, so that the second connecting rod 223 is fastened and electrically connected to the second substrate 21. The second component 222 may be fastened to the second substrate 21 through surface mounting, bonding, or the like, so that the second component 222 is fastened and electrically connected to the second substrate 21.

In some embodiments, when the second component 222 is a chip, and the chip is fastened to the second substrate 21 in a formal mounting manner, in other words, a pin of the chip is located on a surface that is of the chip and that is away from the second substrate 21, and before the chip is fastened and electrically connected to the second substrate 21 through the bonding wire 1221, a metal sheet 225 needs to be pasted on the surface that is of the chip and that is away from the second substrate 21 in a manner of adhesive or welding. In this embodiment, a material of the metal sheet 225 is the same as materials of the second connecting rod 223 and the second heat dissipation block 224. It may be understood that in some embodiments, the material of the metal sheet 225 may be different from the material of the second connecting rod 223 or the second heat dissipation block 224.

Step 220: Refer to FIG. 19g. Package the second package material layer 221 on a surface that is of the second substrate 21 and on which the second connecting rod 223 and the second component 222 are disposed, so that both the second connecting rod 223 and the second component 222 are embedded in the second package material layer 221. The second package material layer 221 is a package material such as resin.

Step 230: Refer to FIG. 19h. Form a groove on a surface that is of the second package material layer 221 and that is away from the second substrate 21, to expose a surface that is of the second connecting rod 223 and that is away from the second substrate 21 and a surface that is of the second component 222 and that is away from the second substrate 21. When the metal sheet 225 is disposed on the surface that is of the second component 222 and that is away from the second substrate 21, in step 230, a groove is formed at the second package material layer 221 to expose the metal sheet 225 disposed on the surface of the second component 222.

In this embodiment, the groove is formed in a laser grooving manner, and a depth of the laser groove may be controlled based on a specific requirement. When the chip is fastened in the formal mounting manner, an active surface of the chip is away from the second substrate 21. During laser grooving, because a position of the grooving is above the chip, to avoid damage to the chip due to insufficient control precision of the grooving depth, the metal sheet is formed on a surface that is of the formal chip and that is away from the second substrate 21, and laser grooving is performed until the metal sheet 225 is exposed, so that damage to the chip caused by laser grooving can be avoided. It may be understood that in some other embodiments of this application, the groove may alternatively be formed in a manner of mold pressing or the like.

Step 240: Refer to FIG. 19i. Form a metal layer 226 on a side that is of the second package material layer 221 and that is away from the first surface, where the metal layer 226 covers the surface that is of the second package material layer 221 and that is away from the second substrate 21, and fills the groove formed in step 130.

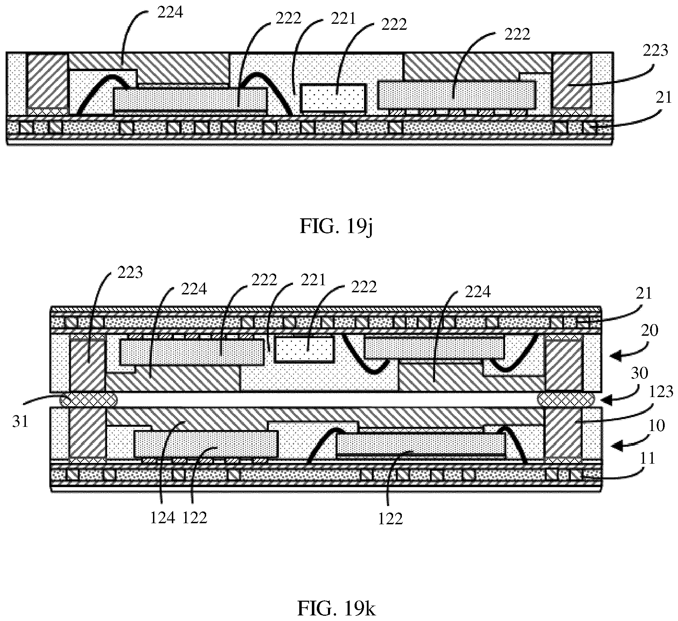

Step 250: Refer to FIG. 19j. Thin the metal layer 226 to an appropriate thickness, to obtain the second heat dissipation block 224 connecting the second component 222 and the second connecting rod 223. In this embodiment, a surface that is of the thinned metal layer 226 and that is away from the second substrate 21 is a plane, to facilitate processing in a subsequent step. It may be understood that in some embodiments, step 150 may not exist.

It may be understood that in some embodiments, when the second package body 20 further includes the third package layer 25, step 210 to step 250 are repeated on a surface that is of the second substrate 21 and that is away from the second component 222, to form the third package layer 25.

Finally, the first package body 10 is fixedly connected to the second package body 20. In some embodiments, that the first package body 10 is fixedly connected to the second package body 20 includes:

Step 310: Refer to FIG. 19k. Fixedly connect the first package body 10 to the second package body 20 through the connection layer 30, and electrically connect the first package body 10 to the second package body 20.

In some embodiments, the connection layer 30 includes the connection sub-block 31. The connection sub-block 31 may be made of solder or conductive adhesive, that is, the first package body 10 is fixedly connected to and electrically connected to the second package body 20 in a soldering or dispensing manner.

In some embodiments, step 310 may be replaced with bonding the first package material layer 211 of the first package body 10 to the second package material layer 221 of the second package body 20, and heating and pressurizing the first package body 10 and the second package body 20. In this way, an intermolecular force is formed between the first heat dissipation block 124 of the first package body 10 and the second heat dissipation block 224 of the second package body 20, so that the first package body 10 is fixedly connected to and electrically connected to the second package body 20.

In this application, a part of heat generated by the first component 122 can be directly transferred to the first substrate 11, and a part of heat is transferred to the first substrate 11 through the first heat dissipation block 124 and the first connecting rod 123 that are connected to the first component 122. In addition, a part of heat generated by the second component 222 can be directly transferred to the second substrate 22, and a part of heat is transferred to the second substrate 21 through the second heat dissipation block 224 and the second connecting rod 223 that are connected to the second component 222. It can be learned from the heat transfer paths of the first component and the second component that there are a plurality of heat transfer paths of the first component and the second component in this application. When the first component or the second component operates and generates heat, heat can be transferred out in time through the plurality of paths, to improve heat transfer efficiency of the package structure, and improve a heat dissipation effect of the package structure, so as to avoid that excessively high heat in a three-dimensional package stacking structure affects proper operation of the components in the package structure or causes damage to the components in the package structure. In addition, in this embodiment of this application, the first connecting rod 123 is connected to the second connecting rod 223, so that the first package body 10 is electrically connected to the second package body 20. In addition, heat generated by a component in the first package body 10 or the second package body 20 can be transferred between the first package body 10 and the second package body 20. This avoids heat accumulation in the first package body 10 or the second package body 20, and avoids damage caused by heat accumulation in the package structure 100.

The foregoing descriptions are preferred implementations of this application. It should be noted that a person of ordinary skill in the art may make several improvements and polishing without departing from the principle of this application, and the improvements and polishing shall fall within the protection scope of this application.

## Claims

1. A package structure, comprising a first package body and a second package body stacked on the first package body, wherein
the first package body comprises a first substrate and a first package layer packaged on the first substrate; a plurality of external pins are formed on a side that is of the first substrate and that is away from the first package layer, and the external pins are configured to connect to an external structure of the package structure; the first package layer comprises a first package material layer and one or more first components and a plurality of first connecting rods that are embedded in the first package material layer; each first component is electrically connected to the first substrate; one end of each first connecting rod is connected to the first substrate, and the other end extends to a surface that is of the first package material layer and that is away from the first substrate; and the first connecting rod is made of a thermal conductive material; and
the second package body comprises a second substrate and a second package layer packaged on the second substrate; the second package layer comprises a second package material layer and one or more second components, a plurality of second connecting rods, and one or more second heat dissipation blocks that are embedded in the second package material layer; each second component is connected to the second substrate; one end of each second connecting rod is connected to the second substrate, and the other end extends to a surface that is of the second package material layer and that is away from the second substrate; each second heat dissipation block is connected to at least one second connecting rod, and each second heat dissipation block is connected to one or more second components; the second connecting rod and the second heat dissipation block are made of a thermal conductive material; and the second substrate or the second connecting rod is connected to the first connecting rod.

2. The package structure according to claim 1, wherein the first package body comprises one or more first heat dissipation blocks, each first heat dissipation block is connected to at least one first connecting rod, each first heat dissipation block is connected to one or more first components, and the first heat dissipation block is made of a thermal conductive material.

3. The package structure according to claim 2, wherein each first heat dissipation block is located on a surface that is of the first component and that is away from the first substrate, and each first connecting rod is closer to an edge of the first package body than the first component; or
each second heat dissipation block is located on a surface that is of the second component and that is away from the second substrate, and the second connecting rod is closer to an edge of the second package body than the second component.

4. The package structure according to claim 3, wherein at least one of the first connecting rods or the second connecting rods is grounded, all the first heat dissipation blocks are integrated and electrically connected to the grounded first connecting rod or the grounded second connecting rod, and all the second heat dissipation blocks are integrated and electrically connected to the grounded first connecting rod or the grounded second connecting rod.

5. The package structure according to claim 2, wherein there are a plurality of first components, a plurality of first heat dissipation blocks, and a plurality of first connecting rods, the plurality of first heat dissipation blocks are disposed at intervals, the first components and the first connecting rods that are connected to different first heat dissipation blocks are different, and the different first heat dissipation blocks are configured to transmit different signals; or
there are a plurality of second components, a plurality of second heat dissipation blocks, and a plurality of second connecting rods, the plurality of second heat dissipation blocks are disposed at intervals, the second components and the second connecting rods that are connected to different second heat dissipation blocks are different, and the different second heat dissipation blocks are configured to transmit different signals.

6. The package structure according to claim 1, wherein an external pin is disposed on a side that is of the second package body and that is away from the first package body, and the external pin is configured to electrically connect to the external structure of the package structure.

7. The package structure according to any one of claims 2 to 6, wherein the second package layer is located on a side that is of the second substrate and that faces the first package layer, and the first connecting rod is connected to the second connecting rod; and
the package structure further comprises a connection layer, and the connection layer is connected between the first package layer and the second package layer, and is connected to the first connecting rod and the second connecting rod.

8. The package structure according to claim 7, wherein the connection layer comprises a plurality of connection sub-blocks disposed at intervals, there are a plurality of first connecting rods and a plurality of second connecting rods, at least a part of the first connecting rods and at least a part of the second connecting rods are disposed opposite to each other, the connection sub-blocks are connected between the first connecting rods and the second connecting rods that are opposite to each other, and the connection sub-blocks are made of a thermal and electrical conductive material.

9. The package structure according to claim 8, wherein a surface that is of the second heat dissipation block and that is away from the second substrate exposes from the second package layer, a surface that is of the first heat dissipation block and that is away from the first substrate exposes from the first package layer, the connection layer further comprises a thermal conductive block, and the thermal conductive block is connected between the surface that is of the first heat dissipation block and that exposes from the first package layer and the surface that is of the second heat dissipation block and that exposes from the second package layer.

10. The package structure according to claims 2 to 6, wherein a surface that is of the second heat dissipation block and that is away from the second substrate exposes from the second package layer, a surface that is of the first heat dissipation block and that is away from the first substrate exposes from the first package layer, the surface that is of the first heat dissipation block and that exposes from the first package layer is in contact with the surface that is of the second heat dissipation block and that exposes from the second package layer, and the first heat dissipation block and the second heat dissipation block form an integrated structure.

11. The package structure according to any one of claims 7 to 10, wherein the second package body further comprises a third package layer, the third package layer is packaged on a surface that is of the second substrate and that is away from the second package layer, the third package layer comprises a third package material layer and one or more third components embedded in the third package material layer, and each third component is connected to the second substrate.

12. The package structure according to claim 11, wherein the third package layer further comprises a plurality of third connecting rods and one or more third heat dissipation blocks that are embedded in the third package material layer, one end of each third connecting rod is connected to the second substrate, the other end extends to a surface that is of the third package material layer and that is away from the second substrate, each third heat dissipation block is connected to at least one third connecting rod, and each third heat dissipation block is connected to the one or more third components.

13. The package structure according to any one of claims 7 to 10, wherein the second substrate comprises a cable layer and an insulation layer covering a side that is of the cable layer and that is away from the second package layer, the second component is electrically connected to the cable layer, and a part of the insulation layer is hollowed out to expose a part of the cable layer; and
a surface that is of the second substrate and that is away from the second package layer is covered with a thermal conductive adhesive layer, the thermal conductive adhesive layer is in contact with the exposed part of the cable layer, and the thermal conductive adhesive layer is configured to transfer heat.

14. The package structure according to claim 13, wherein a release film is disposed on a surface that is of the thermal conductive adhesive layer and that is away from the second package layer.

15. The package structure according to claim 2, wherein the first component comprises a formal chip, a metal sheet is stacked on a surface that is of the formal chip and that is away from the first substrate, and the first heat dissipation block is connected to the metal sheet; or
the second component comprises a formal chip, a metal sheet is stacked on a surface that is of the formal chip and that is away from the second substrate, and the second heat dissipation block is connected to the metal sheet.

16. The package structure according to claim 1, wherein there are a plurality of first components on the first substrate, and at least two of the plurality of first components are stacked in a thickness direction of the first package body; or
there are a plurality of second components on the second substrate, and at least two of the plurality of second components are stacked in a thickness direction of the second package body.

17. An electronic apparatus, wherein the electronic apparatus comprises a function module and the package structure according to any one of claims 1 to 16, and the function module is electrically connected to the package structure.

18. The electronic apparatus according to claim 17, wherein the electronic apparatus comprises a mainboard, the package structure and the function module are fastened on the mainboard and are electrically connected to the mainboard, and the first substrate of the package structure is closer to the mainboard than the first package layer and is electrically connected to the mainboard through the external pin.

19. The electronic apparatus according to claim 18, wherein the electronic apparatus comprises a middle frame, the middle frame is disposed opposite to the mainboard, the package structure is located between the middle frame and the mainboard and is connected to the middle frame and the mainboard, a surface that is of the second package body of the package structure and that is away from the first substrate is connected to the middle frame, and the middle frame is configured to dissipate heat.

20. The electronic apparatus according to any one of claims 17 to 19, wherein the electronic device is a mobile phone, and the function module comprises one or more of an antenna module, a sensor module, an audio module, a camera module, a connector module, and a power module.
